(19) Europäisches Patentamt
European Patent Office
Office européen des brevets

(11) EP 1 398 336 B1

(12) **EUROPEAN PATENT SPECIFICATION**

(45) Date of publication and mention of the grant of the patent:
**26.10.2005 Bulletin 2005/43**

(51) Int Cl.7: **C08G 61/12**

(21) Application number: **03018346.1**

(22) Date of filing: **13.08.2003**

(54) **Mono-, Oligo- and Poly(3-alkynylthiophenes) and their Use as Charge Transport Materials**

Mono-,Oligo- und Poly(3-Alkynylthiophene) und ihre Verwendung als Ladungstransportmaterialien

Mono-, Oligo- et Poly(3-alkynylthiophenes) et leur utilisation comme matériaux de transport de charges

(84) Designated Contracting States:
**AT BE BG CH CY CZ DE DK EE ES FI FR GB GR HU IE IT LI LU MC NL PT RO SE SI SK TR**

(30) Priority: **14.09.2002 EP 02020711**

(43) Date of publication of application:
**17.03.2004 Bulletin 2004/12**

(73) Proprietor: **Merck Patent GmbH**
**64293 Darmstadt (DE)**

(72) Inventors:
- **Heeney, Martin**
  **Southampton SO14 6TQ (GB)**
- **Tierney, Steven**
  **Southampton SO15 7QW (GB)**
- **Bailey, Clare**
  **Southampton, Hamshire SO18 4PP (GB)**
- **McCulloch, Iain**
  **Southampton SO53 4LG (GB)**

(56) References cited:
**EP-A- 1 028 136**
**WO-A-88/00954**
**US-A- 5 185 100**

- **MCCULLOUGH R D: "THE CHEMISTRY OF CONDUCTING POLYTHIOPHENES" ADVANCED MATERIALS, VCH VERLAGSGESELLSCHAFT, WEINHEIM, DE, vol. 10, no. 2, 22 January 1998 (1998-01-22), pages 93-116, XP000727852 ISSN: 0935-9648**

EP 1 398 336 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

### Field of Invention

The invention relates to new conjugated mono-, oligo- and poly(3-alkynylthiophenes). The invention further relates to methods for their preparation, their use as semiconductors or charge transport materials in optical, electrooptical or electronic devices including field effect transistors, electroluminescent, photovoltaic and sensor devices. The invention further relates to field effect transistors and semiconducting components comprising the new mono-, oligo- and polymers.

### Background and PriorArt

Organic materials have recently shown promise as the active layer in organic based thin film transistors and organic field effect transistors [see H. E. Katz et al., *Acc. Chem. Res.*, 2001, **34**, 5, 359]. Such devices have potential applications in smart cards, security tags and the switching element in flat panel displays. Organic materials are envisaged to have substantial cost advantages over their silicon analogues if they can be deposited from solution, as this enables a fast, large-area fabrication route.

The performance of the device is principally based upon the charge carrier mobility of the semiconducting material and the current on/off ratio, so the ideal semiconductor should have a low conductivity in the off state, combined with a high charge carrier mobility ($> 1 \times 10^{-3}$ $cm^2 V^{-1} s^{-1}$). In addition, it is important that the semiconducting material is relatively stable to oxidation, i.e., it has a high ionisation potential, as oxidation leads to reduced device performance.

A known compound which has been shown to be an effective p-type semiconductor for OFETs is pentacene [see S. F. Nelson et al., *Appl. Phys. Lett.,* 1998, **72**, 1854]. When deposited as a thin film by vacuum deposition, it was shown to have carrier mobilities in excess of 1 $cm^2 V^{-1} s^{-1}$ with very high current on/off ratios greater than $10^6$. However, vacuum deposition is an expensive processing technique that is unsuitable for the fabrication of large-area films.

Regioregular head-to-tail poly(3-hexylthiophene) has been reported with charge carrier mobility between $1 \times 10^{-5}$ and $4.5 \times 10^{-2}$ $cm^2 V^{-1} s^{-1}$, but with a rather low current on/off ratio between 10 and $10^3$ [see Z. Bao et al., *Appl. Pys. Lett.,* 1996, **69**, 4108]. This low on/off current is due in part to the low ionisation potential of the polymer, which can lead to oxygen doping of the polymer under ambient conditions, and a subsequent high off current [see H. Sirringhaus et al., *Adv. Solid State Phys.*, 1999, **39,** 101]. A high regioregularity leads to improved packing and optimised microstructure, leading to improved charge carrier mobility [see H. Sirringhaus et al., *Science*, 1998, **280**, 1741-1744; H. Sirringhaus et al., *Nature,* 1999, **401**, 685-688; and H. Sirringhaus, et al., *Synthetic Metals*, 2000, **111-112**, 129-132]. In general, poly(3-alkylthiophenes) show improved solubility and are able to be solution processed to fabricate large area films. However, poly(3-alkylthiophenes) have relatively low ionisation potentials and are susceptible to doping in air.

It is an aim of the present invention to provide new materials for use as semiconductors or charge transport materials, which are easy to synthesize, have high charge mobility, good processibility and oxidative stability. Other aims of the invention are immediately evident to those skilled in the art from the following description.

The inventors have found that these aims can be achieved by providing novel polymers based on 3-alkynylthiophene (**1**). In particular, novel regioregular head-to-tail poly(3-alkynylthiophenes) according to the present invention are advantageous as they show strong interchain π-π-stacking interactions and a high degree of crystallinity, making them effective charge transport materials with high carrier mobilities. In addition, the introduction of an alkynyl functionality in the 3-position leads to an increase in the ionisation potential of the polymer, compared e.g. to poly(3-alkylthiophene) (PAT) which is known on prior art, due to the electron withdrawing nature of the triple bond. Triple bonds have positive Hammett constants (both $\sigma^-_{para}$ and $\sigma_{meta}$) which are indicative of both an inductive and resonant withdrawing effect [E.J.A. Dean, *Lange's Handbook of Chemistry*, *12th Edition,* 1979, 3-134]. When used in a semiconductor device, this reduces oxygen doping of the semiconductor and improves the on/off ratio of the device.

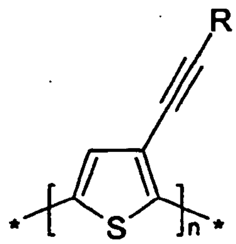

1

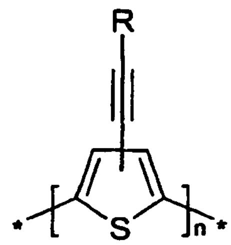

2

Furthermore, alkyl substituents (R) can be incorporated to solubilise the novel polymers (**1**) and to promote crystallinity and so make them readily solution processible. Solution processing has the advantage over vacuum deposition processing of being a potentially cheaper and faster technique. Furthermore, the synthetic route affords material of high regioregularity, which has been shown to improve packing density and optimise microstructure, leading to high carrier mobility (see above).

A further aspect of the invention relates to the synthesis of novel, regiorandom poly(3-alkynyl)thiophenes (**2**) which are amorphous in character and have improved electroluminescent properties compared to the more ordered regioregular polymer, especially when carrying a bulky substituent R, like for example adamantyl, cyclohexyl or pyrenyl.

A further aspect of the invention relates to reactive mesogens having a central core comprising one or more 3-alkynylthiophene units, and optionally contain further unsaturated organic groups that form a conjugated system together with the 3-alkynylthiophene units, said core being linked, optionally via a spacer group, to one or two polymerisable groups. The reactive mesogens can induce or enhance liquid crystal phases or are liquid crystalline themselves. They can be oriented in their mesophase and the polymerisable group(s) can be polymerised or crosslinked in situ to form polymer films with a high degree of order, thus yielding improved semiconductor materials with high stability and high charge carrier mobility.

Grell et al., J. *Korean Phys. Soc.*, 2000, **36**(6), 331 suggest a reactive mesogen comprising a conjugated distyrylbenzene core with two reactive acrylate end groups as a model compound for molecular electronics. However, there is no disclosure of reactive mesogens of 3-alkynylthiophene.

A further aspect of the invention relates to liquid crystal polymers, in particular liquid crystal side chain polymers obtained from the reactive mesogens according to the present invention, which are then further processed, e.g., from solution as thin layers for use in semiconductor devices.

## Definition of Terms

The terms 'liquid crystalline or mesogenic material' or 'liquid crystalline or mesogenic compound' means materials or compounds comprising one or more rod-shaped, lath-shaped or disk-shaped mesogenic groups, i.e., groups with the ability to induce liquid crystal phase behaviour. The compounds or materials comprising mesogenic groups do not necessarily have to exhibit a liquid crystal phase themselves. It is also possible that they show liquid crystal phase behaviour only in mixtures with other compounds, or when the mesogenic compounds or materials, or the mixtures thereof, are polymerised.

The term 'polymerisable' includes compounds or groups that are capable of participating in a polymerisation reaction, like radicalic or ionic chain polymerisation, polyaddition or polycondensation, and reactive compounds or reactive groups that are capable of being grafted for example by condensation or addition to a polymer backbone in a polymeranaloguous reaction.

The term 'film' includes self-supporting, i.e., free-standing, films that show more or less pronounced mechanical stability and flexibility, as well as coatings or layers on a supporting substrate or between two substrates.

## Summay of the Invention

The invention relates to mono-, oligo- and polymers of formula I

$$-[(A)_a-(B)_b-(C)_c-(D)_d]_n- \qquad \text{I}$$

in particular to mono-, oligo- and polymers of formula I1

$$R^4\text{-}[(A)_a\text{-}(B)_b\text{-}(C)_c\text{-}(D)_d]_n\text{-}R^5 \qquad \text{I1}$$

wherein

A and C denote independently of each other a group of formula II

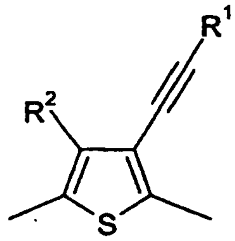

II

$R^1$ is in each occurence independently of one another H, halogen, straight chain, branched or cyclic alkyl with 1 to 20 C-atoms, which is unsubstituted, mono- or poly-substituted by F, Cl, Br, I or CN, wherein one or more non-adjacent $CH_2$ groups are optionally replaced, in each case independently from one another, by -O-, -S-, -NH-, -$NR^0$-, -$SiR^0R^{00}$-, -CO-, -COO-, -OCO-, -OCO-O-, -$SO_2$-, -S-CO-, -CO-S-, -CH=CH- or -C≡C- in such a manner that O and/or S atoms are not linked directly to one another, or denotes optionally substituted aryl or heteroaryl or P-Sp-,

$R^2$ has one of the meanings of $R^1$ or denotes -C≡C-$R^3$,

$R^3$ has one of the meanings of $R^1$,

$R^4$ and $R^5$ have independently of each other one of the meanings of $R^1$, or denote B(OR')(OR'') or $SnR^0R^{00}R^{000}$,

$R^{0-000}$ are independently of each other H or alkyl with 1 to 12 C-atoms,

R' and R'' are independently of each other H or alkyl with 1 to 12 C-atoms, or OR' and OR'' together with the boron atom form a cyclic group having 2 to 10 C atoms,

P is a polymerisable or reactive group,

Sp is a spacer group or a single bond,

B and D are independently of each other -$CX^1$=$CX^2$-, -C≡C-, or optionally substituted arylene or heteroarylene,

$X^1$ and $X^2$ are independently of each other H, F, Cl or CN,

a, b, c, d are independently of each other 0 or 1, with a + b + c + d > 0, and wherein in at least one recurring unit $[(A)_a\text{-}(B)_b\text{-}(C)_c\text{-}(D)_d]$ at least one of a and c is 1, and

n is an integer ≥ 1,

wherein the recurring units $[(A)_a\text{-}(B)_b\text{-}(C)_c\text{-}(D)_d]$ can be identical or different.

The invention further relates to the use of mono-, oligo- and polymers according to the invention as semiconductors or charge transport materials, in particular in optical, electrooptical or electronic devices, like for example components of integrated circuitry, field effect transistors (FET) for example as thin film transistors in flat panel display applications or for Radio Frequency Identification (RFID) tags, or in semiconducting components for organic light emitting diode (OLED) applications such as electroluminescent displays or backlights of, e.g., liquid crystal displays, for

photovoltaic or sensor devices, as electrode materials in batteries, as photoconductors and for electrophotographic applications like electrophotographic recording.

The invention further relates to a field effect transistor, for example as a component of integrated circuitry, as a thin film transistor in flat panel display applications, or in a Radio Frequency Identification (RFID) tag, comprising one or more mono-, oligo- or polymers according to the invention.

The invention further relates to a semiconducting component, for example in OLED applications like electroluminescent displays or backlights of, e.g., liquid crystal displays, in photovoltaic or sensor devices, as electrode materials in batteries, as photoconductors and for electrophotographic applications, comprising one or more mono-, oligo- or polymers according to the invention.

The invention further relates to a security marking or device comprising an RFID or ID tag or a FET according to the invention.

Detailed Description of the Invention

The mono-, oligo- and polymers according to the present invention are especially useful as charge transport semiconductors in that they have high carrier mobilities. Particularly preferred are mono-, oligo- and polymers wherein $R^1$ and/or $R^2$ in the groups A and C denote alkyl or fluoroalkyl groups. The introduction of alkyl and fluoroalkyl side chains to the groups A and C improves the solubility and therefore the solution processibility of the inventive materials. Furthermore, the presence of fluoroalkyl side chains also renders the inventive materials effective as n-type semiconductors.

In particular, regioregular head-to-tail poly(3-alkynylthiophenes) according to the present invention are advantageous as they show strong interchain $\pi$-$\pi$-stacking interactions and a high degree of crystallinity, making them effective charge transport materials with high carrier mobilities. The presence of the alkynyl functionality in the 3-position leads to an increase in the ionisation potential of the polymer, and, when used in a semiconductor device, reduces oxygen doping of the semiconductor and improves the on/off ratio of the device.

Particularly preferred are mono-, oligo- and polymers comprising at least one group of formula II and at least one reactive group that is capable of a polymerisation or crosslinking reaction.

Further preferred are mono-, oligo- and polymers comprising at least one group of formula II that are mesogenic or liquid crystalline, in particular polymers of formula I or I1 forming calamitic phases, and reactive mesogens of formula I or I1, comprising one or more groups P-Sp-X, forming calamitic phases.

In the oligo- and polymers of the present invention the recurring units $[(A)_a\text{-}(B)_b\text{-}(C)_c\text{-}(D)_d]$ in case of multiple occurrence can be selected of formula I independently of each other, so that an oligo- or polymer may comprise identical or different recurring units $[(A)_a\text{-}(B)_b\text{-}(C)_c\text{-}(D)_d]$. The oligo- and polymers thus include homopolymers and copolymers like for example

- statistically random copolymers, for example with a monomer sequence such as -A-B-C-C-B-D-A-B-D- or -A-C-A-A-C-,
- alternating copolymers, for example with a monomer sequence such as -A-B-C-D-A-B-C-D- or -A-B-C-A-B-C-, and
- block copolymers, for example with a monomer sequence such as -A-A-B-B-B-B-C-C-C-D-D-D-,

wherein the groups A, B, C and D preferably together form a conjugated system.

Further preferred are mono-, oligo- and polymers comprising one or more recurring units $[(A)_a\text{-}(B)_b\text{-}(C)_c\text{-}(D)_d]$, wherein a = 1 and b = c = d = 0, very preferably consisting exclusively of such recurring units.

Further preferred are mono-, oligo- and polymers comprising one or more recurring units $[(A)_a\text{-}(B)_b\text{-}(C)_c\text{-}(D)_d]$, wherein b = c = d = 1 and a = 0, very preferably consisting exclusively of such recurring units. Further preferred are mono-, oligo- and polymers comprising one or more recurring units $[(A)_a\text{-}(B)_b\text{-}(C)_c\text{-}(D)_d]$, wherein a = b = c = 1 and d = 0, very preferably consisting exclusively of such recurring units.

Further preferred are mono-, oligo- and polymers comprising one or more recurring units $[(A)_a\text{-}(B)_b\text{-}(C)_c\text{-}(D)_d]$, wherein a = b = 1 and c = d = 0, very preferably consisting exclusively of such recurring units.

Further preferred are mono-, oligo- and polymers of formula I and I1 wherein

- n is an integer from 1 to 5000,
- n is an integer from 2 to 5000, in particular from 20 to 1000,
- n is an integer from 2 to 5,

- n is 2 and one or both of $R^4$ and 5 denote P-Sp-,
- n is an integer from 1 to 15 and one or both of $R^4$ and $R^5$ denote P-Sp-,
- n is an integer from 2 to 5000 and $R^4$ and $R^5$ are not P-Sp-,
- the molecular weight is from 5000 to 100000,
- $R^2$ is H,
- $R^2$ is -C≡C-$R^3$ and $R^1$ and $R^3$ are identical,
- $R^1$, $R^2$ and/or $R^3$ are selected from $C_1$-$C_{20}$-alkyl that is optionally substituted with one or more fluorine atoms, $C_1$-$C_{20}$-alkenyl, $C_1$-$C_{20}$-alkynyl, $C_1$-$C_{20}$-alkoxy, $C_1$-$C_{20}$-thioalkyl, $C_1$-$C_{20}$-silyl, $C_1$-$C_{20}$-ester, $C_1$-$C_{20}$-amino, $C_1$-$C_{20}$-fluoroalkyl, or optionally substituted aryl or heteroaryl, in particular $C_1$-$C_{20}$-alkyl or $C_1$-$C_{20}$-fluoroalkyl,
- $R^4$ and $R^5$ are selected from $C_1$-$C_{20}$-alkyl that is optionally substituted with one or more fluorine atoms, $C_1$-$C_{20}$-alkenyl, $C_1$-$C_{20}$-alkynyl, $C_1$-$C_{20}$-alkoxy, $C_1$-$C_{20}$-thioalkyl, $C_1$-$C_{20}$-silyl, $C_1$-$C_{20}$-ester, $C_1$-$C_{20}$-amino, $C_1$-$C_{20}$-fluoroalkyl, and optionally substituted aryl or heteroaryl,
- B and D are optionally substituted arylene or heteroarylene,
- B and D are -$CX^1$=$CX^2$- or -C≡C-,
- in at least one recurring unit $[(A)_a-(B)_b-(C)_c-(D)_d]$, a = b = c = 1 and d = 0, and B is arylene or heteroarylene or -$CX^1$=$CX^2$- or -C≡C-,
- n>1.

Especially preferred are mono-, oligo- and polymers selected from the following formulae

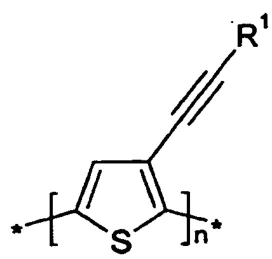

Ia

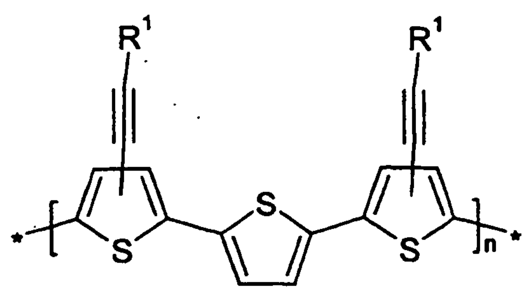

Ib

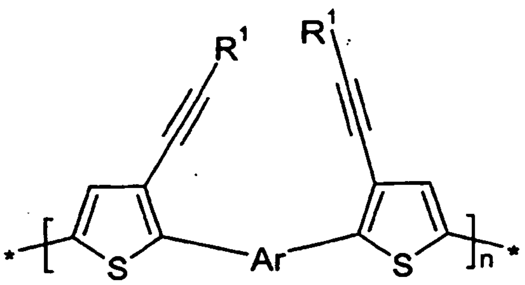

Ic

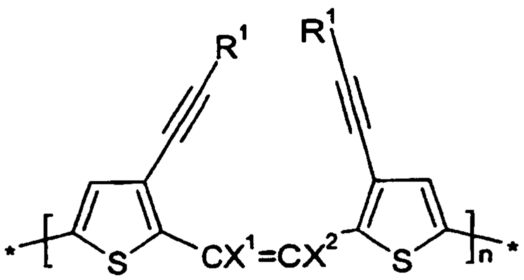

Id

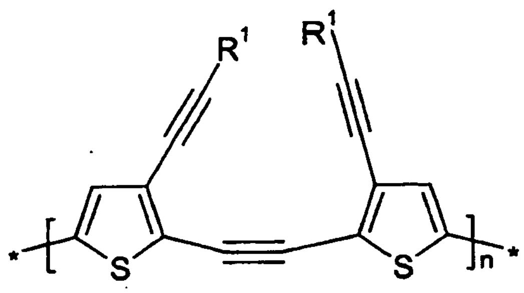

Ie

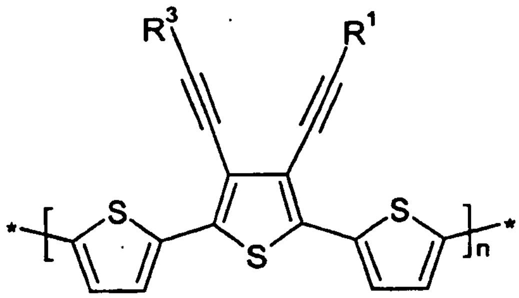

If

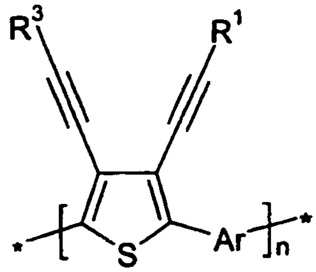

Ig

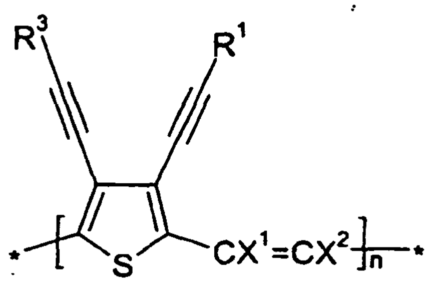

Ih

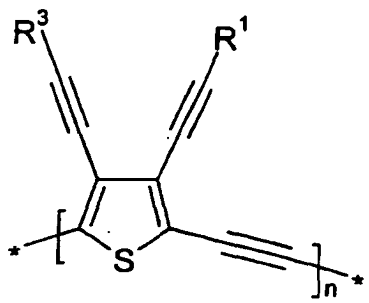

Ii

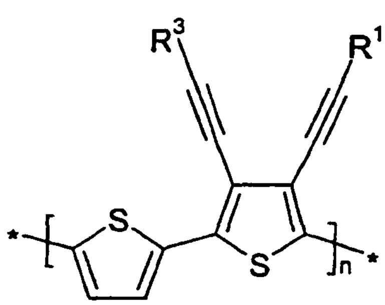

Ik

wherein $R^1$,$R^3$, $X^1$ and $X^2$ have the meanings given above, Ar is arylene or heteroarylene which in each case is optionally substituted by one or more groups $R^1$ as defined in formula I, and n is an integer from 1 to 5000.

Especially preferred are regioregular polymers of formula I or I1, in particular regioregular homopolymers containing recurring units of formula II or of the preferred formulae shown above, very preferably regioregular head-to-tail.poly(3-alkynylthiophenes) of formula Ia. The regioregularity in these polymers is preferably at least 90 %, in particular 95% or more, very preferably 98% or more, most preferably from 99 to 100%.

Particularly preferred are oligo- and polymers of formula I or I1 comprising recurring units selected from the above preferred formulae Ia to Ii, wherein n is an integer from 2 to 5000, in particular from 20 to 1000, $R^1$ is alkyl with

1-16 C-atoms that is optionally fluorinated, Ar is 1,4-phenylene, alkoxyphenylene, alkylfluorene, thiophene-2,5-diyl, thienothiophene-2,5-diyl or dithienothiophene-2,6-diyl, $X^1$ and $X^2$ are H, CN or F, and wherein $R^4$ and $R^5$ are independently of each other H, halogen, alkyl with 1-16 C atoms that is optionally fluorinated, or P-Sp-.

Further preferred are reactive monomers of formula I or I1 comprising recurring units selected from the above preferred formulae Ia to Ii, wheren n is 2, $R^1$ is alkyl with 1-16 C-atoms that is optionally fluorinated, Ar is 1,4-phenylene, alkoxyphenylene, alkylfluorene, thiophene-2,5-diyl, thienothiophene-2,5-diyl or dithienothiophene-2,6-diyl, $X^1$ and $X^2$ are H, CN or F, and wherein one of $R^4$ and $R^5$ is H, halogen, alkyl with 1-16 C atoms that is optionally fluorinated, or P-Sp-, and the other is P-Sp-.

Aryl and heteroaryl preferably denote a mono-, bi- or tricyclic aromatic or heteroaromatic with up to 25 C atoms, wherein the rings can be fused, and in which the heteroaromatic groups contain at least one hetero ring atom, preferably selected from N, O and S. The aryl and heteroaryl groups are optionally substituted with one or more of F, Cl, Br, I, CN, and straight chain, branched or cyclic alkyl having 1 to 20 C atoms, which is unsubstituted, mono- or poly-substituted by F, Cl, Br, I, -CN or -OH, and in which one or more non-adjacent $CH_2$ groups are optionally replaced, in each case independently from one another, by -O-, -S-, -NH-, $-NR^0-$, $-SiR^0R^{00}-$, -CO-, -COO-, OCO-, -OCO-O, -S-CO-, -CO-S-,-CH=CH- or -C≡C- in such a manner that O and/or S atoms are not linked directly to one another.

Especially preferred aryl and heteroaryl groups are phenyl in which, in addition, one or more CH groups may be replaced by N, naphthalene, thiophene, thienothiophene, dithienothiophene, alkyl fluorene and oxazole, all of which are unsubstituted, mono- or polysubstituted with L, wherein L is halogen or an alkyl, alkoxy, alkylcarbonyl or alkoxycarbonyl group with 1 to 12 C atoms, wherein one or more H atoms are optionally replaced by F or Cl.

Arylene and heteroarylene preferably denote a mono-, bi- or tricyclic divalent aromatic or heteroaromatic radicals with up to 25 C atoms, wherein the rings can be fused, and in which the heteroaromatic groups contain at least one hetero ring atom, preferably selected from N, O and S. The arylene and heteroarylene groups are optionally substituted with one or more of F, Cl, Br, I, CN, and straight chain, branched or cyclic alkyl having 1 to 20 C atoms, which is unsubstituted, mono- or poly-substituted by F, Cl, Br, I, -CN or -OH, and in which one or more non-adjacent $CH_2$ groups are optionally replaced, in each case independently from one another, by -O-, -S-, -NH-, $-NR^0-$, $-SiR^0R^{00}-$, -CO-, -COO-, OCO-, -OCO-O, -S-CO-, -CO-S-,-CH=CH- or -C ≡C- in such a manner that O and/or S atoms are not linked directly to one another.

Especially preferred arylene and heteroarylene groups are 1,4-phenylene in which, in addition, one or more CH groups are optionally replaced by N, naphthalene-2,6-diyl, thiophene-2,5-diyl, thienothiophene-2,5-diyl, dithienothiophene-2,6-diyl, alkyl fluorene and oxazole, all of which are unsubstituted, mono- or polysubstituted with L as defined above.

$CX^1=CX^2$ is preferably -CH=CH-, -CH=CF-, -CF=CH-, -CF=CF-, -CH=C(CN)- or -C(CN)=CH-.

If in the formulae shown above and below one of $R^1$ to $R^5$ is an alkyl or alkoxy radical, i.e., where the terminal $CH_2$ group is replaced by -O-, this may be straight-chain or branched. It is preferably straight-chain, has 2 to 8 carbon atoms and accordingly is preferably ethyl, propyl, butyl, pentyl, hexyl, heptyl, octyl, ethoxy, propoxy, butoxy, pentoxy, hexyloxy, heptoxy, or octoxy, furthermore methyl, nonyl, decyl, undecyl, dodecyl, tridecyl, tetradecyl, pentadecyl, nonoxy, decoxy, undecoxy, dodecoxy, tridecoxy or tetradecoxy, for example.

Oxaalkyl, i.e., where one $CH_2$ group is replaced by -O-, is preferably straight-chain 2-oxapropyl (=methoxymethyl), 2- (=ethoxymethyl) or 3-oxabutyl (=2-methoxyethyl), 2-, 3-, or 4-oxapentyl, 2-, 3-, 4-, or 5-oxahexyl, 2-, 3-, 4-, 5-, or 6-oxaheptyl, 2-, 3-, 4-, 5-, 6- or 7-oxaoctyl, 2-, 3-, 4-, 5-, 6-, 7- or 8-oxanonyl or 2-, 3-, 4-, 5-, 6-,7-, 8- or 9-oxadecyl, for example.

Fluoroalkyl is preferably $C_iF_{2i+1}$, wherein i is an integer from 1 to 15, in particular $CF_3$, $C_2F_5$, $C_3F_7$, $C_4F_9$, $C_5F_{11}$, $C_6F_{13}$, $C_7F_{15}$ or $C_8F_{17}$, very preferably $C_6F_{13}$.

Halogen is preferably F, Br or Cl.

Hetero atoms are preferably selected from N, O and S.

The polymerisable or reactive group P is preferably selected from $CH_2=CW^1-COO-$,

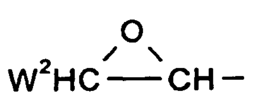 , 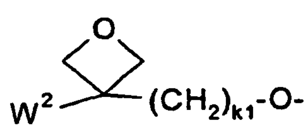 ,

$CH_2=CW^2-(O)_{k1}-$, $CH_3-CH=CH-O-$, $(CH_2=CH)_2CH-OCO-$, $(CH_2=CH-CH_2)_2CH-OCO-$, $(CH_2=CH)_2CH-O-$, $(CH_2=CH-CH_2)_2N-$, $HO-CW^2W^3-$, $HS-CW^2W^3-$, $HW^2N-$, $HO-CW^2W^3-NH-$, $CH_2=CW^1-CO-NH-$, $CH_2=CH-(COO)_{k1}-Phe-(O)_{k2}-$, Phe-CH=CH-, HOOC-, OCN-, and $W^4W^5W^6Si-$, with $W^1$ being H, Cl, CN, phenyl or alkyl with 1 to 5 C-atoms, in particular H, Cl or $CH_3$, $W^2$ and $W^3$ being independently of each other H or alkyl with 1 to 5 C-atoms, in particular methyl, ethyl or n-propyl, $W^4$, $W^5$ and $W^6$ being independently of each other Cl, oxaalkyl or oxacarbonylalkyl

with 1 to 5 C-atoms, Phe being 1,4-phenylene and $k_1$ and $k_2$ being independently of each other 0 or 1.

Especially preferred groups P are $CH_2$=CH-COO-, $CH_2$=C($CH_3$)-COO-, $CH_2$=CH-, $CH_2$=CH-O-, ($CH_2$=CH)$_2$CH-OCO-, ($CH_2$=CH)$_2$CH-O-, and

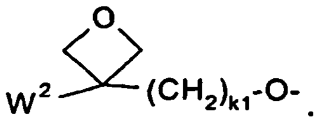

Very preferred are acrylate and oxetane groups. Oxetanes produce less shrinkage upon polymerisation (cross-linking), which results in less stress development within films, leading to higher retention of ordering and fewer defects. Oxetane cross-linking also requires cationic initiator, which unlike free radical initiator is inert to oxygen.

As for the spacer group Sp all groups can be used that are known for this purpose to the skilled in the art. The spacer group Sp is preferably of formula Sp'-X, such that P-Sp- is P-Sp'-X-, wherein

| | |
|---|---|
| Sp' | is alkylene with up to 20 C atoms which may be unsubstituted, mono- or poly-substituted by F, Cl, Br, I or CN, it being also possible for one or more non-adjacent $CH_2$ groups to be replaced, in each case independently from one another, by -O-, -S-, -NH-, -$NR^0$-, -Si$R^0R^{00}$-, -CO-, -COO-, -OCO-, -OCO-O-, -S-CO-, -CO-S-, -CH=CH- or -C≡C- in such a manner that O and/or S atoms are not linked directly to one another, |
| X | is -O-, -S-, -CO-, -COO-, -OCO-, -O-COO-, -CO-$NR^0$-, -$NR^0$-CO-, -O$CH_2$-, -$CH_2$O-, -S$CH_2$-, -$CH_2$S-, -$CF_2$O-, -O$CF_2$-, -$CF_2$S-, -S$CF_2$-, -$CF_2CH_2$-, -$CH_2CF_2$-, -$CF_2CF_2$-, -CH=N-, -N=CH-, -N=N-, -CH=C$R^0$-, -C$X^1$=C$X^2$-, -C≡C-, -CH=CH-COO-, -OCO-CH=CH- or a single bond, and |
| $R^0$, $R^{00}$, $X^1$ and $X^2$ | have one of the meanings given above. |

X is preferably -O-, -S-, -O$CH_2$-, -$CH_2$O-, -S$CH_2$-, -$CH_2$S-, -$CF_2$O-, -O$CF_2$-, -$CF_2$S-, -S$CF_2$-, -$CH_2CH_2$-, -$CF_2CH_2$-, -$CH_2CF_2$-, -$CF_2CF_2$-, -CH=N-, -N=CH-, -N=N-, -CH=C$R^0$-, -C$X^1$=C$X^2$-, -C≡C- or a single bond, in particular -O-, -S-, -C≡C-, -C$X^1$=C$X^2$- or a single bond, very preferably a group that is able to from a conjugated system, such as -C≡C- or -C$X^1$=C$X^2$-, or a single bond.

Typical groups Sp' are, for example, -($CH_2$)$_p$-, -($CH_2CH_2$O)$_q$-$CH_2CH_2$-, -$CH_2CH_2$-S-$CH_2CH_2$- or -$CH_2CH_2$-NH-$CH_2CH_2$- or -(Si$R^0R^{00}$-O)$_p$-, with p being an integer from 2 to 12, q being an integer from 1 to 3 and $R^0$ and $R^{00}$ having the meanings given above.

Preferred groups Sp' are ethylene, propylene, butylene, pentylene, hexylene, heptylene, octylene, nonylene, decylene, undecylene, dodecylene, octadecylene, ethyleneoxyethylene, methyleneoxybutylene, ethylene-thioethylene, ethylene-N-methyliminoethylene, 1-methylalkylene, ethenylene, propenylene and butenylene for example.

Further preferred are compounds with one or two groups P-Sp- wherein Sp is a single bond.

In case of compounds with two groups P-Sp-, each of the two polymerisable groups P and the two spacer groups Sp can be identical or different.

SCLCPs obtained from the inventive compounds or mixtures by polymerisation or copolymerisation have a backbone that is formed by the polymerisable group P in formula I.

The mono-, oligo- and polymers of the present invention can be synthesized according to or in analogy to known methods. Some preferred methods are described below. Therein, R has one of the meanings of $R^1$ in formula I.

Synthesis of regioregular head-to-tail poly(3-alkynylthiophene) (**1**): Route 1

Starting from commercially available 3-iodothiophene (**3**), a route to poly(3-alkynylthiophene) (**1**) is outlined in scheme 1 below. 3-Iodothiophene (**3**) is brominated in the 2,5-positions with *N*-bromosuccinimide NBS to afford to 2,5-dibromo-3-iodothiophene [see S. Gronowitz et al., *Acta Chemica Scandinavica B,* 1976, **30**, 423-429]. Subsequent reaction with a terminal alkyne under Sonogashira conditions affords 2,5-dibromo-3-alkynylthiophene (**4**). Poly(3-alkynylthiophene) (**1**) is synthesised from (**4**) by the route described by McCullough [see R.S. Loewe et al., *Macromolecules*, 2000, p. A-J, and R. D. McCullough, US Patent 6,166,172]. Treatment with one equivalent of an alkyl or vinyl Grignard reaction results in a Grignard metathesis to form the aryl Grignard reagent. Addition of a catalytic amount of Ni(dppp)$Cl_2$ affords regioregular head-to-tail poly(3-alkynylthiophene) (**1**). Polymerisation can also be performed by the route described by Rieke [see T.-A- Chen and R.D. Rieke, *J. Am. Chem. Soc.*, 1992, **114**, 10087]. Treatment of with highly

active zinc dust affords the organozinc intermediate, which is polymerised by reaction with catalytic Ni(dppp)$Cl_2$. Polymerisation of (**4**) can also be performed by Stille or Suzuki methodology [see S. Guillerez and G. Bidan, *Synthetic Metals*, 1998, **93**, 123; and A. Iraqi and G.W. Barker, *Journal of Materials Chemistry*, 1998. **8**(1), 25-29].

<u>Scheme 1:</u>

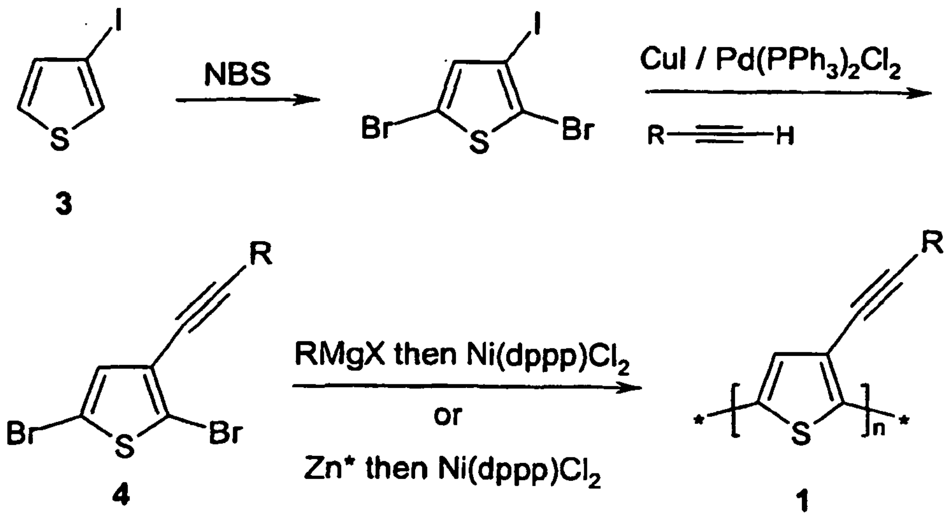


3

4

1

<u>Synthesis of regioregular head-to-tail poly(3-alkynylthiophene) (**1**): Route 2</u>

An alternative route to key intermediate 2,5-dibromo-3-alkynylthiophene (**4**) is outlined in scheme 2. Readily available 3-bromothiophene is cross-coupled with an alkynylzinc reagent in the presence of a palladium catalyst to afford 3-alkynylthiophene (**5**). The alkynyzinc reagent is formed by treatment of a terminal alkyne with butyllithium to afford the alkynyllithium *in situ,* subsequent treatment with zinc chloride forms the organozinc reagent. Alternatively cross-coupling of 3-bromothiophene with a terminal alkyne in the presence of copper and palladium catalysts under Sonogashira conditions affords (**5**). The 3-alkynylthiophene can be dilithiated with 2 equivalents of butyl lithium and the di-lithio intermediate quenched with iodine or a bromine source (NBS or carbon tetrabromide) to afford the 2,5-diiodo-3-alkynylthiophene or 2,5-dibromo-3-alkynylthiophene (**4**) respectively. Polymerisation can occur via the methods described above.

Scheme 2:

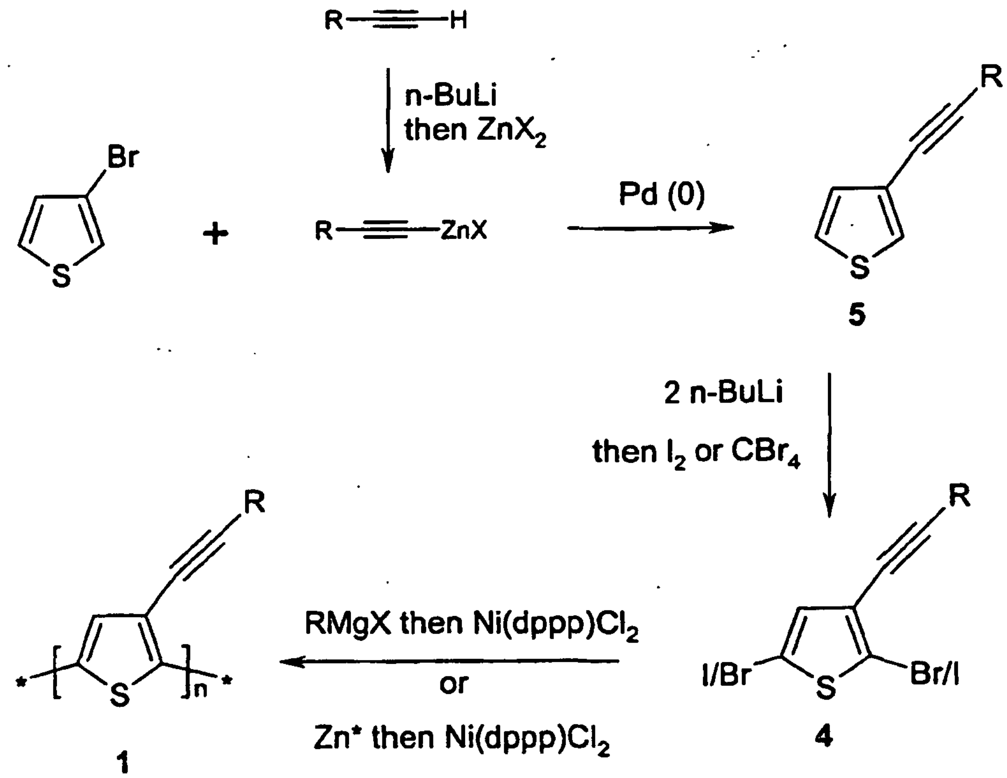


5, 4, 1

Synthesis of regioregular head-to-tail poly(3-alkynylthiophene) (**1**): Route 3

Starting from commercially available 3-iodothiophene (**3**), a route to poly(3-alkynylthiophene) (**1**) is outlined in scheme 3 below. 3-Iodothiophene (**3**) is brominated selectively in the 2-position with *N*-bromosuccinimide NBS to afford to 2-bromo-3-iodothiophene. [see S. Gronowitz et al., *Acta Chemica Scandinavica B*, 1976, **30**, 423-429]. Subsequent reaction with a terminal alkyne under Sonogashira conditions affords 2-bromo-3-alkynylthiophene (**6**). Poly (3-alkynylthiophene) (**1**) is synthesised from (**6**) by the route described by McCullough [see R. D. McCullough et al., *J. Org. Chem.,* 1993, **58**, 904]. Treatment with one equivalent of lithium diisopropylamide (LDA) results in selective lithiation of (**6**). The lithio species is treated with $MgBr_2.Et_2O$ to form the aryl Grignard reagent. Addition of a catalytic amount of $Ni(dppp)Cl_2$ affords regioregular head-to-tail poly(3-alkynylthiophene) (**1**). A modified version of this method can also be performed whereby $ZnCl_2$ is used instead of $MgBr_2.Et_2O$ to form the aryl zinc reagent.

**Scheme 3:**

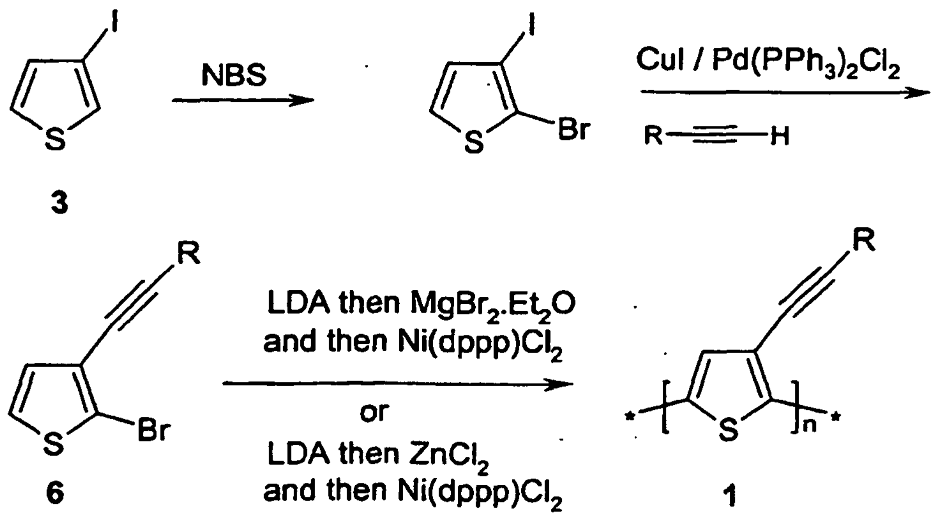


3 6 1

Synthesis of regiorandom poly(3-alkynylthiophene):

Regiorandom poly(alkynyl)thiophene (**2**) is readily synthesised by the treatment of 3-alkynylthiophene (**5**) with a solution of ferric chloride as shown in scheme 4.

**Scheme 4:**

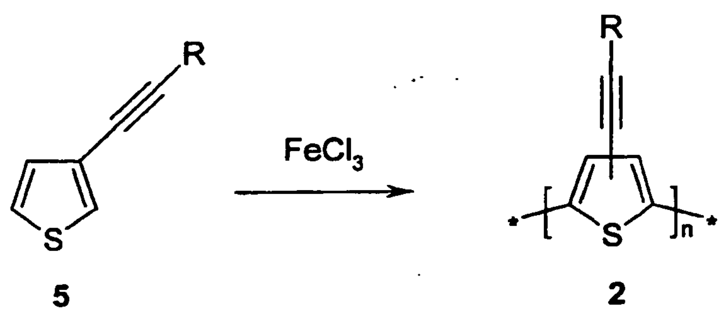


5 2

Reactive mesogens

Compounds of formula I or I1 comprising polymerisable groups P can be synthesized according or in analogy to the following methods.

According to scheme 5, 2-bromo-3-alkynylthiophene (**4**) is cross-coupled with an alkyl Grignard reagent in the presence of a nickel catalyst to yield protected mono-alkyl alcohol (**7**). Subsequent bromination occurs in the 5 position. A cross-coupling reaction with an aryl bisorganotin or bisboronic ester affords bis- alcohol (**8**). Routine methodology converts the bis-alcohol (**8**) into the bisacrylate or bis-oxetane.

Scheme 5:

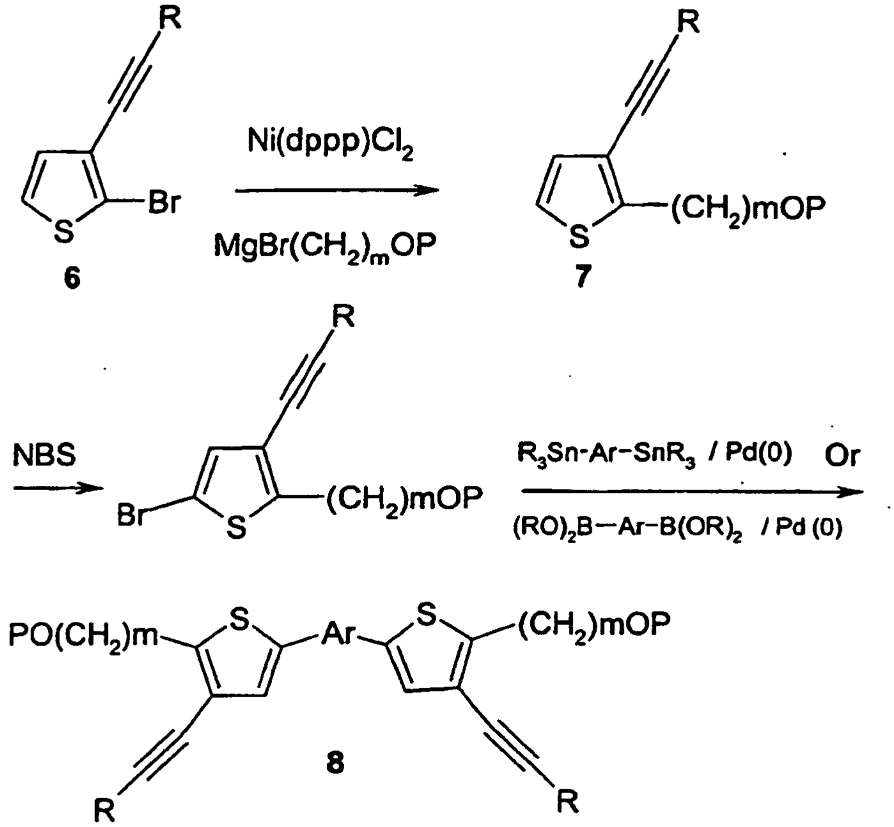


6 7 8

Polymerisation of reactive mesogens can be carried out for example by thermal cross-linking or photoinitiated cross-linking.

Polymers containing conjugated groups C≡C, $CX^1$=$CX^2$ or Ar

The Stille coupling of 2,5-dibromo-3-(alkynyl)thiophene (**4**) with the bis-organotin reagent (**9**) yields polymer (**10**) containing $CX^1$=$CX^2$ groups. Coupling of **4** with an aryl bis(organotin) reagent or with an aryl bisboronic ester affords polymers containing an aryl group (**11**) (scheme 6).

Scheme 6:

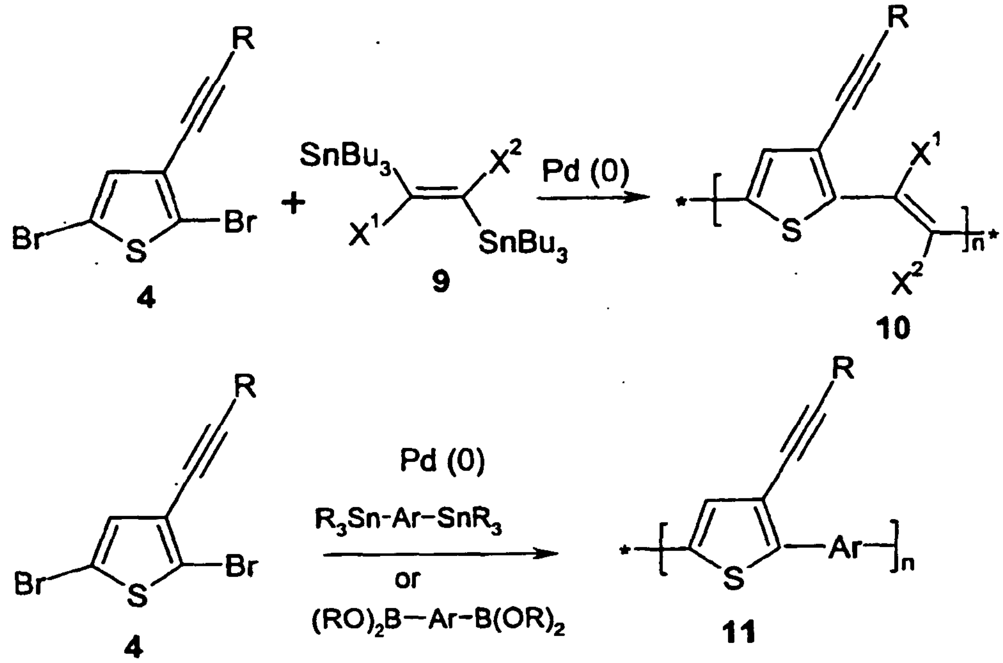


4 + 9 → 10

4 → 11

The reaction of 2-bromo-3-alkynylthiophene (**6**) with a bis organotin reagent affords dithiophene (**12**). This is readily polymerised by treatment with ferric chloride to afford regioregular polymer (**13**) (scheme 7)

Scheme 7:

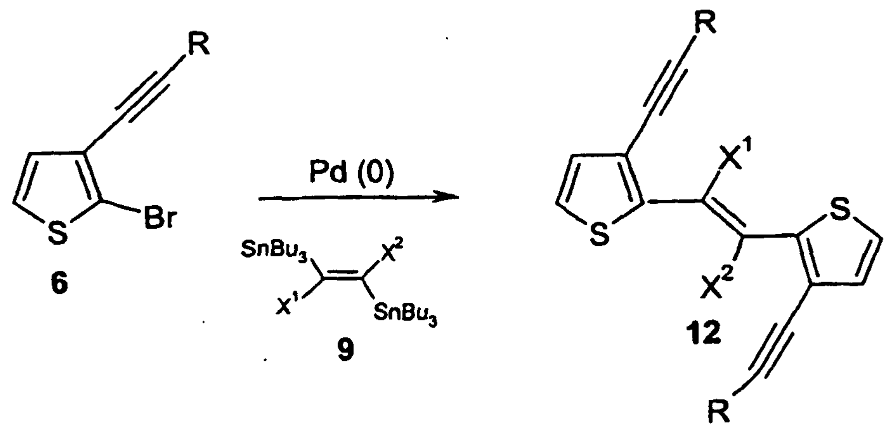


6, 9 → 12

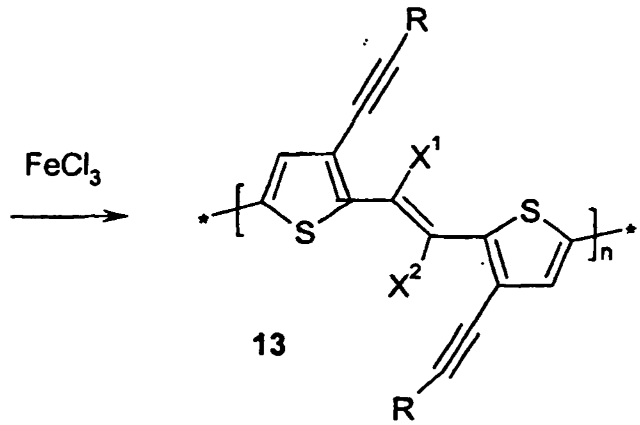


13

A further aspect of the invention relates to both the oxidised and reduced form of the compounds and materials according to this invention. Either loss or gain of electrons results in formation of a highly delocalised ionic form, which is of high conductivity. This can occur on exposure to common dopants. Suitable dopants and methods of doping are known to those skilled in the art, e.g., from EP 0 528 662, US 5,198,153 or WO 96/21659.

The doping process typically implies treatment of the semiconductor material with an oxidating or reducing agent in a redox reaction to form delocalised ionic centres in the material, with the corresponding counterions derived from the applied dopants. Suitable doping methods comprise for example exposure to a doping vapor in the atmospheric pressure or at a reduced pressure, electrochemical doping in a solution containing a dopant, bringing a dopant into contact with the semiconductor material to be thermally diffused, and ion-implantantion of the dopant into the semiconductor material.

When electrons are used as carriers, suitable dopants are for example halogens (e.g., $I_2$, $Cl_2$, $Br_2$, ICl, $ICl_3$, IBr and IF), Lewis acids (e.g., $PF_5$, $AsF_5$, $SbF_5$, $BF_3$, $BCl_3$, $SbCl_5$, $BBr_3$ and $SO_3$), protonic acids, organic acids, or amino acids (e.g., HF, HCl, $HNO_3$, $H_2SO_4$, $HClO_4$, $FSO_3H$ and $ClSO_3H$), transition metal compounds (e.g., $FeCl_3$, FeOCl, $Fe(ClO_4)_3$, $Fe(4\text{-}CH_3C_6H_4SO_3)_3$, $TiCl_4$, $ZrCl_4$, $HfCl_4$, $NbF_5$, $NbCl_5$, $TaCl_5$, $MoF_5$, $MoCl_5$, $WF_5$, $WCl_6$, $UF_6$ and $LnCl_3$ (wherein Ln is a lanthanoid), anions (e.g., $Cl^-$, $Br^-$, $I^-$, $I_3^-$, $HSO_4^-$, $SO_4^{2-}$, $NO_3^-$, $ClO_4^-$, $BF_4^-$, $PF_6^-$, $AsF_6^-$, $SbF_6^-$, $FeCl_4^-$, $Fe(CN)_6^{3-}$, and anions of various sulfonic acids, such as aryl-$SO_3^-$). When holes are used as carriers, examples of dopants are cations (e.g., $H^+$, $Li^+$, $Na^+$, $K^+$, $Rb^+$ and $Cs^+$), alkali metals (e.g., Li, Na, K, Rb, and Cs), alkaline-earth metals (e.g., Ca, Sr, and Ba), $O_2$, $XeOF_4$, $(NO_2^+)$ $(SbF_6^-)$, $(NO_2^+)$ $(SbCl_6^-)$, $(NO_2^+)$ $(BF_4^-)$, $AgClO_4$, $H_2IrCl_6$, $La(NO_3)_3 \cdot 6H_2O$, $FSO_2OOSO_2F$, Eu, acetylcholine, $R_4N^+$, (R is an alkyl group), $R_4P^+$ (R is an alkyl group), $R_6As^+$ (R is an alkyl group), and $R_3S^+$ (R is an alkyl group).

The conducting form of the compounds and materials of the present invention can be used as an organic "metal" in applications, for example, but not limited to, charge injection layers and ITO planarising layers in organic light emitting diode applications, films for flat panel displays and touch screens, antistatic films, printed conductive substrates, patterns or tracts in electronic applications such as printed circuit boards and condensers.

A preferred embodiment of the present invention relates to mono-, oligo- and polymers of formula I or I1 that are mesogenic or liquid crystalline, and very preferably comprise one or more polymerisable groups. Very preferred materials of this type are monomers and oligomers of formula I1 wherein n is an integer from 1 to 15 and $R^4$ and/or $R^5$ denote P-Sp-.

These materials are particularly useful as semiconductors or charge transport materials, as they can be aligned into uniform highly ordered orientation in their liquid crystal phase by known techniques, thus exhibiting a higher degree of order that leads to particularly high charge carrier mobility. The highly ordered liquid crystal state can be fixed by in situ polymerisation or crosslinking via the groups P to yield polymer films with high charge carrier mobility and high thermal, mechanical and chemical stability.

For example, if a device is made from a polymerisable liquid crystal material by polymerisation in situ, the liquid crystal material preferably comprises one or more mono- or oligomers of formula I1 and its preferred subformulae wherein one or both of $R^4$ and $R^5$ denote P-Sp-. If a liquid crystal polymer is preapred first, for example by polymerisation in solution, and the isolated polymer is used to make the device, the polymer is preferably made from a liquid crystal material comprising one or more mono- or oligomers of formula I1 and its preferred subformulae wherein one of $R^4$ and $R^5$ denotes P-Sp-.

It is also possible to copolymerise the polymerisable mono-, oligo- and polymers according to the present invention with other polymerisable mesogenic or liquid crystal monomers that are known from prior art, in order to

induce or enhance liquid crystal phase behaviour.

Thus, another aspect of the invention relates to a polymerisable liquid crystal material comprising one or more mono-, oligo- or polymers of the present invention as described above and below comprising at least one polymerisable group, and optionally comprising one or more further polymerisable compounds, wherein at least one of the polymerisable mono-, oligo- and polymers of the present invention and/or the further polymerisable compounds is mesogenic or liquid crystalline.

Particularly preferred are liquid crystal materials having a nematic and/or smectic phase. For FET applications smectic materials are especially preferred. For OLED applications nematic or smectic materials are especially preferred.

Another aspect of the present invention relates to an anisotropic polymer film with charge transport properties obtainable from a polymerisable liquid crystal material as defined above that is aligned in its liquid crystal phase into macroscopically uniform orientation and polymerised or crosslinked to fix the oriented state.

Polymerisation is preferably carried out by in-situ polymerisation of a coated layer of the material, preferably during fabrication of the electronic or optical device comprising the inventive semiconductor material. In case of liquid crystal materials, these are preferably aligned in their liquid crystal state into homeotropic orientation prior to polymerisation, where the conjugated pi-electron systems are orthogonal to the direction of charge transport. This ensures that the intermolecular distances are minimised and hence then energy required to transport charge between molecules is minimised. The molecules are then polymerised or crosslinked to fix the uniform orientation of the liquid crystal state. Alignment and curing are carried out in the liquid crystal phase or mesophase of the material. This technique is known in the art and is generally described for example in D.J. Broer, et al., Angew. Makromol. Chem. 183, (1990), 45-66

Alignment of the liquid crystal material can be achieved for example by treatment of the substrate onto which the material is coated, by shearing the material during or after coating, by application of a magnetic or electric field to the coated material, or by the addition of surface-active compounds to the liquid crystal material. Reviews of alignment techniques are given for example by I. Sage in "Thermotropic Liquid Crystals", edited by G. W. Gray, John Wiley & Sons, 1987, pages 75-77, and by T. Uchida and H. Seki in "Liquid Crystals - Applications and Uses Vol. 3", edited by B. Bahadur, World Scientific Publishing, Singapore 1992, pages 1-63. A review of alignment materials and techniques is given by J. Cognard, Mol. Cryst. Liq. Cryst. 78, Supplement 1 (1981), pages 1-77.

Polymerisation takes place by exposure to heat or actinic radiation. Actinic radiation means irradiation with light, like UV light, IR light or visible light, irradiation with X-rays or gamma rays or irradiation with high energy particles, such as ions or electrons. Preferably polymerisation is carried out by UV irradiation at a non-absorbing wavelength. As a source for actinic radiation for example a single UV lamp or a set of UV lamps can be used. When using a high lamp power the curing time can be reduced. Another possible source for actinic radiation is a laser, like e.g. a UV laser, an IR laser or a visible laser.

Polymerisation is preferably carried out in the presence of an initiator absorbing at the wavelength of the actinic radiation. For example, when polymerising by means of UV light, a photoinitiator can be used that decomposes under UV irradiation to produce free radicals or ions that start the polymerisation reaction. When curing polymerisable materials with acrylate or methacrylate groups, preferably a radical photoinitiator is used, when curing polymerisable materials with vinyl, epoxide and oxetane groups, preferably a cationic photoinitiator is used. It is also possible to use a polymerisation initiator that decomposes when heated to produce free radicals or ions that start the polymerisation. As a photoinitiator for radical polymerisation for example the commercially available Irgacure 651, Irgacure 184, Darocure 1173 or Darocure 4205 (all from Ciba Geigy AG) can be used, whereas in case of cationic photopolymerisation the commercially available UVI 6974 (Union Carbide) can be used.

The polymerisable material can additionally comprise one or more other suitable components such as, for example, catalysts, sensitizers, stabilizers, inhibitors, chain-transfer agents, co-reacting monomers, surface-active compounds, lubricating agents, wetting agents, dispersing agents, hydrophobing agents, adhesive agents, flow improvers, defoaming agents, deaerators, diluents, reactive diluents, auxiliaries, colourants, dyes or pigments.

Mono-, oligo- and polymers comprising one or more groups P-Sp- can also be copolymerised with polymerisable mesogenic compounds to induce, or, in case of mesogenic materials of formula I or I1, enhance liquid crystal phase behaviour. Polymerisable mesogenic compounds that are suitable as comonomers are known in prior art and disclosed for example in WO 93/22397; EP 0,261,712; DE 195,04,224; WO 95/22586 and WO 97/00600.

Another aspect of the invention relates to a liquid crystal side chain polymer (SCLCP) obtained from a polymerisable liquid crystal material as defined above by polymerisation or polymeranaloguous reaction. Particularly preferred are SCLCPs obtained from one or more monomers according to formula I1 wherein one or both of $R^4$ and $R^5$ are a polymerisable or reactive group, or from a polymerisable mixture comprising one or more of such monomers of formula I1.

Another aspect of the invention relates to an SCLCP obtained from one or more monomers of formula I1 wherein one or both of $R^4$ and $R^5$ are a polymerisable group, or from a polymerisable liquid crystal mixture as defined above, by copolymerisation or polymeranaloguous reaction together with one or more additional mesogenic or non-mesogenic comonomers.

Side chain liquid crystal polymers or copolymers (SCLCPs), in which the semiconducting component is located as a pendant group, separated from a flexible backbone by an aliphatic spacer group, offer the possibility to obtain a highly ordered lamellar like morphology. This structure consists of closely packed conjugated aromatic mesogens, in which very close (typically < 4 Å) pi-pi stacking can occur. This stacking allows intermolecular charge transport to occur more easily, leading to high charge carrier mobilities. SCLCPs are advantageous for specific applications as they can be readily synthesized before processing and then e.g. be processed from solution in an organic solvent. If SCLCPs are used in solutions, they can orient spontaneously when coated onto an appropriate surface and when at their mesophase temperature, which can result in large area, highly ordered domains.

SCLCPs can be prepared from the polymerisable compounds or mixtures according to the invention by the methods described above, or by conventional polymerisation techniques which are known to those skilled in the art, including for example radicalic, anionic or cationic chain polymerisation, polyaddition or polycondensation. Polymerisation can be carried out for example as polymerisation in solution, without the need of coating and prior alignment, or polymerisation in situ. It is also possible to form SCLCPs by grafting compounds according to the invention with a suitable reactive group, or mixtures thereof, to presynthesized isotropic or anisotropic polymer backbones in a polymeranaloguous reaction. For example, compounds with a terminal hydroxy group can be attached to polymer backbones with lateral carboxylic acid or ester groups, compounds with terminal isocyanate groups can be added to backbones with free hydroxy groups, compounds with terminal vinyl or vinyloxy groups can be added, e.g., to polysiloxane backbones with Si-H groups. It is also possible to form SCLCPs by copolymerisation or polymeranaloguous reaction from the inventive compounds together with conventional mesogenic or non mesogenic comonomers. Suitable comonomers are known to those skilled in the art. In principle it is possible to use all conventional comonomers known in the art that carry a reactive or polymerisable group capable of undergoing the desired polymer-forming reaction, like for example a polymerisable or reactive group P as defined above. Typical mesogenic comonomers are for example those mentioned in WO 93/22397, EP 0 261 712, DE 195 04 224, WO 95/22586, WO 97/00600 and GB 2 351 734. Typical non mesogenic comonomers are for example alkyl mono- or diacrylates or alkyl mono- or dimethacrylates with alkyl groups of 1 to 20 C atoms, like methyl acrylate or methyl methacrylate, trimethylpropane trimethacrylate or pentaerythritol tetraacrylate.

The mono-, oligo- and polymers of the present invention are useful as optical, electronic and semiconductor materials, in particular as charge transport materials in field effect transistors (FETs), e.g., as components of integrated circuitry, ID tags or TFT applications. Alternatively, they may be used in organic light emitting diodes (OLEDs) in electroluminescent display applications or as backlight of, e.g., liquid crystal displays, as photovoltaics or sensor materials, for electrophotographic recording, and for other semiconductor applications.

Especially the oligomers and polymers according to the invention show advantageous solubility properties which allow production processes using solutions of these compounds. Thus films, including layers and coatings, may be generated by low cost production techniques, e.g., spin coating. Suitable solvents or solvent mixtures comprise alkanes and/ or aromatics, especially their fluorinated derivatives.

The materials of the present invention are useful as optical, electronic and semiconductor materials, in particular as charge transport materials in field effect transistors (FETs), as photovoltaics or sensor materials, for electrophotographic recording, and for other semiconductor applications. Such FETs, where an organic semiconductive material is arranged as a film between a gate-dielectric and a drain and a source electrode, are generally known, e.g., from US 5,892,244, WO 00/79617, US 5,998,804, and from the references cited in the background and prior art chapter and listed below. Due to the advantages, like low cost production using the solubility properties of the compounds according to the invention and thus the processibility of large surfaces, preferred applications of these FETs are such as integrated circuitry, TFT-displays and security applications.

In security applications, field effect transistors and other devices with semiconductive materials, like transistors or diodes, may be used for ID tags or security markings to authenticate and prevent counterfeiting of documents of value like banknotes, credit cards or ID cards, national ID documents, licenses or any product with money value, like stamps, tickets, shares, cheques etc..

Alternatively, the mono-, oligo- and polymers according to the invention may be used in organic light emitting devices or diodes (OLEDs), e.g., in display applications or as backlight of e.g. liquid crystal displays. Common OLEDs are realized using multilayer structures. An emission layer is generally sandwiched between one or more electron-transport and/ or hole-transport layers. By applying an electric voltage electrons and holes as charge carriers move towards the emission layer where their recombination leads to the excitation and hence luminescence of the lumophor units contained in the emission layer. The inventive compounds, materials and films may be employed in one or more of the charge transport layers and/or in the emission layer, corresponding to their electrical and/ or optical properties. Furthermore their use within the emission layer is especially advantageous, if the compounds, materials and films according to the invention show electroluminescent properties themselves or comprise electroluminescent groups or compounds. The selection, characterization as well as the processing of suitable monomeric, oligomeric and polymeric

compounds or materials for the use in OLEDs is generally known by a person skilled in the art, see, e.g., Meerholz, Synthetic Materials, 111-112, 2000, 31-34, Alcala, J. Appl. Phys., 88, 2000, 7124-7128 and the literature cited therein.

According to another use, the inventive compounds, materials or films, especially those which show photoluminescent properties, may be employed as materials of light sources, e.g., of display devices such as described in EP 0 889 350 A1 or by C. Weder et al., Science, 279, 1998, 835-837.

## Claims

**1.** Mono-, oligo- and polymers of formula I

$$-[(A)_a-(B)_b-(C)_c-(D)_d]_n- \qquad \text{I}$$

wherein

A and C denote independently of each other a group of formula II

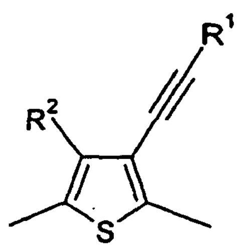

II

$R^1$ is in each occurence independently of one another H, halogen, straight chain, branched or cyclic alkyl with 1 to 20 C-atoms, which is unsubstituted, mono- or poly-substituted by F, Cl, Br, I or CN, wherein one or more non-adjacent $CH_2$ groups are optionally replaced, in each case independently from one another, by -O-, -S-, -NH-, $-NR^0-$, $-SiR^0R^{00}-$, -CO-, -COO-, -OCO-, -OCO-O-, $-SO_2-$, -S-CO-, -CO-S-, -CH=CH- or -C≡C- in such a manner that O and/or S atoms are not linked directly to one another, or denotes optionally substituted aryl or heteroaryl or P-Sp-X,

$R^2$ has one of the meanings of $R^1$ or denotes $-C\equiv C-R^3$,

$R^3$ has one of the meanings of $R^1$,

$R^0$ and $R^{00}$ are independently of each other H or alkyl with 1 to 12 C-atoms,

P is a polymerisable or reactive group,

Sp is a spacer group or a single bond,

B and D are independently of each other $-CX^1=CX^2-$, -C≡C-, or optionally substituted arylene or heteroarylene,

$X^1$ and $X^2$ are independently of each other H, F, Cl or CN,

a, b, c, d are independently of each other 0 or 1, with a + b + c + d > 0, and wherein in at least one recurring unit $A)_a-(B)_b-(C)_c-(D)_d]$ at least one of a and c is 1, and

n is an integer ≥ 1,

and wherein the recurring units $[(A)_a-(B)_b-(C)_c-(D)_d]$ are identical or different.

**2.** Mono-, oligo- and polymers according to claim 1, selected of formula I1

$$R^4\text{-}[(A)_a\text{-}(B)_b\text{-}(C)_c\text{-}(D)_d]_n\text{-}R^5 \qquad \text{I1}$$

wherein A, B, C, D, a, b, c, d and n are as defined in formula I,

$R^4$ and $R^5$ have independently of each other one of the meanings of $R^1$, or denote B(OR')(OR") or $SnR^0R^{00}R^{000}$,

$R^{0-000}$ are independently of each other H or alkyl with 1 to 12 C-atoms, and

R' and R" are independently of each other H or alkyl with 1 to 12 C-atoms, or OR' and OR" together with the boron atom form a cyclic group having 2 to 10 C atoms.

**3.** Mono-, oligo- and polymers according to claim 1 or 2, wherein n is an integer from 1 to 5000.

**4.** Mono-, oligo- and polymers according to at least one of claims 1 to 3, wherein $R^1$, $R^2$ and/or $R^3$ are selected from $C_1$-$C_{20}$-alkyl that is optionally substituted with one or more fluorine atoms, $C_1$-$C_{20}$-alkenyl, $C_1$-$C_{20}$-alkynyl, $C_1$-$C_{20}$-alkoxy, $C_1$-$C_{20}$-thioether, $C_1$-$C_{20}$-silyl, $C_1$-$C_{20}$-ester, $C_1$-$C_{20}$-amino, $C_1$-$C_{20}$-fluoroalkyl, or optionally substituted aryl or heteroaryl.

**5.** Mono-, oligo- and polymers according to claim 4, wherein $R^2$ is $-C{\equiv}C-R^3$ and $R^1$ and $R^3$ are identical groups as defined in formula I.

**6.** Mono-, oligo- and polymers according to at least one of claims 2 to 5, wherein n is an integer from 1 to 15 and one or both of $R^4$ and $R^5$ denote P-Sp-.

**7.** Oligo- and polymers according to at least one of claims 1 to 6, wherein n is an integer from 2 to 5000.

**8.** Mono-, oligo- and polymers according to at least one of claims 1 to 7, wherein P is selected from $CH_2=CW^1-COO-$,

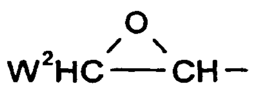,

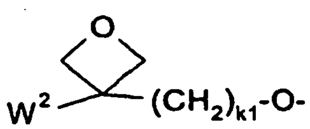,

$CH_2=CW^2-(O)_{k1}-$, $CH_3-CH=CH-O-$, $(CH_2=CH)_2CH-OCO-$, $(CH_2=CH-CH_2)_2CH-OCO-$, $(CH_2=CH)_2CH-O-$, $(CH_2=CH-CH_2)_2N-$, $HO-CW^2W^3-$, $HS-CW^2W^3-$, $HW^2N-$, $HO-CW^2W^3-NH-$, $CH_2=CW^1-CO-NH-$, $CH_2=CH-(COO)_{k1}-Phe-(O)_{k2}-$, $Phe-CH=CH-$, $HOOC-$, $OCN-$, and $W^4W^5W^6Si-$, with $W^1$ being H, Cl, CN, phenyl or alkyl with 1 to 5 C-atoms, in particular H, Cl or $CH_3$, $W^2$ and $W^3$ being independently of each other H or alkyl with 1 to 5 C-atoms, in particular methyl, ethyl or n-propyl, $W^4$, $W^5$ and $W^6$ being independently of each other Cl, oxaalkyl or oxacarbonylalkyl with 1 to 5 C-atoms, Phe being 1,4-phenylene and $k_1$ and $k_2$ being independently of each other 0 or 1.

**9.** Mono-, oligo- and polymers according to at least one of claims 1 to 8, selected from the following formulae

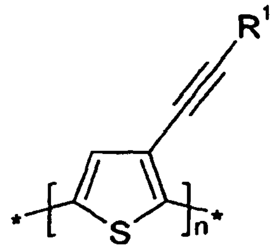

Ia

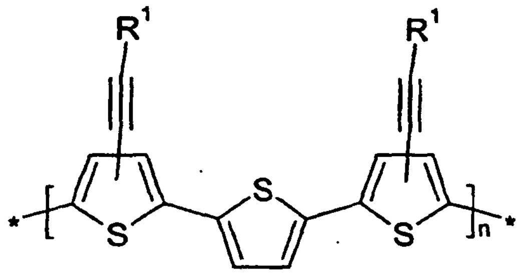

Ib

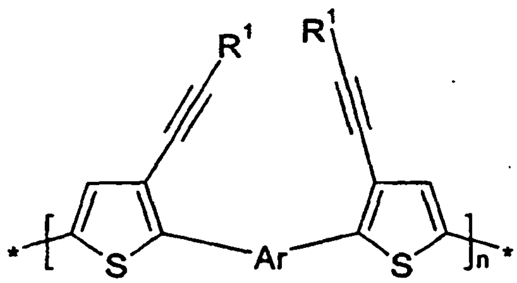

Ic

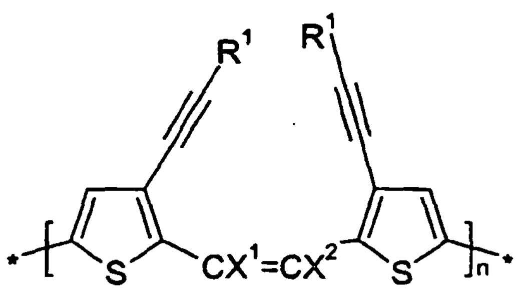

Id

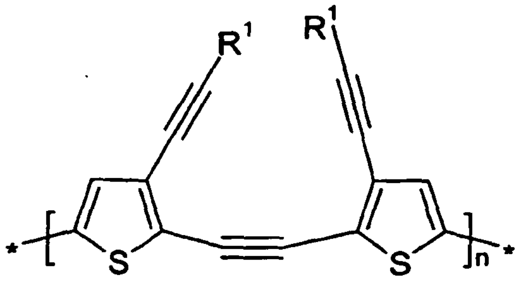

Ie

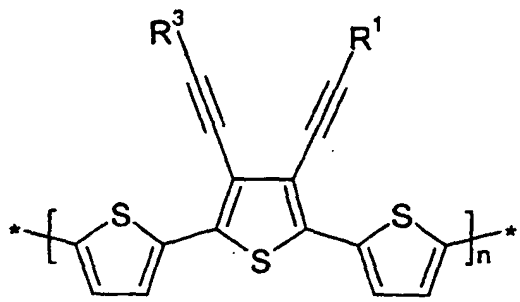

If

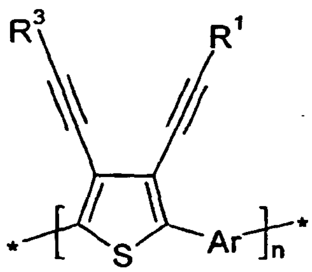

Ig

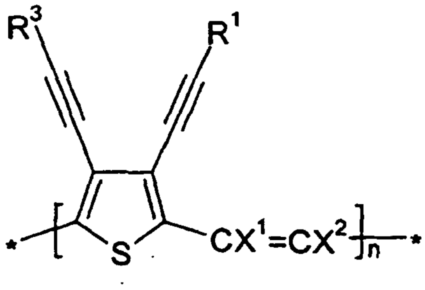

Ih

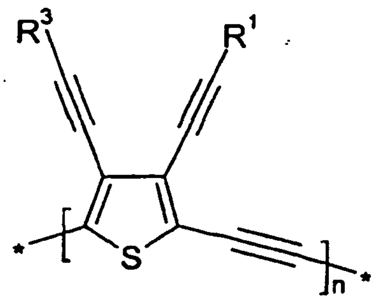

Ii

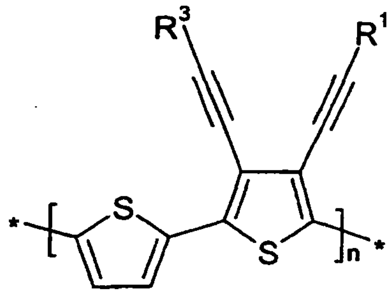

Ik

wherein $R^1$, $R^3$, $X^1$ and $X^2$ have the meanings given in formula I, Ar is arylene or heteroarylene which in each case is optionally substituted by one or more groups $R^1$ as defined in formula I, and n is an integer from 1 to 5000.

**10.** Polymer according to at least one of claims 1 to 9, **characterized in that** it has a regioregularity of from 90 to 100 %.

**11.** Polymerisable liquid crystal material comprising one or more mono-, oligo- or polymers of at least one of claims 1 to 10 comprising at least one polymerisable group, and optionally comprising one or more further polymerisable compounds, wherein at least one of the polymerisable mono-, oligo- and polymers of claims 1 to 8 and/or the further polymerisable compounds is mesogenic or liquid crystalline.

**12.** Anisotropic polymer film with charge transport properties obtainable from a polymerisable liquid crystal material according to claim 11 that is aligned in its liquid crystal phase into macroscopically uniform orientation and polymerised or crosslinked to fix the oriented state.

**13.** Side chain liquid crystal polymer obtained by polymerisation of one or more mono- or oligomers or a polymerisable material according to claims 1 to 11 or by grafting one or more mono- or oligomers or a polymerisable material according to claims 1 to 11 to a polymer backbone in a polymeranaloguous reaction, optionally with one or more additional mesogenic or non-mesogenic comonomers.

**14.** Use of the mono-, oligo- and polymers, polymerisable material and polymer of claims 1 to 13 as semiconductors or charge transport materials, in particular in optical, electrooptical or electronic devices, like for example components of integrated circuitry, field effect transistors (FET) for example as thin film transistors in flat panel display applications or for Radio Frequency Identification (RFID) tags, or in semiconducting components for organic light emitting diode (OLED) applications such as electroluminescent displays or backlights of e.g. liquid crystal displays, for photovoltaic or sensor devices, as electrode materials in batteries, as photoconductors and for electrophotographic applications like electrophotographic recording.

**15.** Field effect transistor, for example as a component of integrated circuitry, as a thin film transistor in flat panel display applications, or in a Radio Frequency Identification (RFID) tag, comprising one or more mono-, oligo- or polymers according to the invention comprising one or more mono-, oligo- or polymers, polymerisable material or polymer of claims 1 to 13.

16. Security marking or device comprising comprising one or more mono-, oligo- or polymers, a polymerisable material or a polymer of claims 1 to 13, or a FET or RFID tag according to claim 15.

17. Mono-, oligo- and polymers, a material or polymer according to at least one of claims 1 to 13, which are oxidatively or reductively doped to form conducting ionic species.

18. Charge injection layer, planarising layer, antistatic film or conducting substrate or pattern for electronic applications or flat panel displays, comprising mono-, oligo- or polymers, a material or polymer film according to claim 17.

**Patentansprüche**

1. Mono-, Oligo- und Polymere der Formel I

$$-[(A)_a-(B)_b-(C)_c-(D)_d]_n- \quad \text{I}$$

worin

A und C unabhängig voneinander eine Gruppe der Formel II

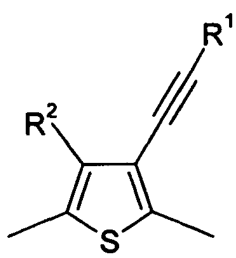

II

bedeuten,

$R^1$ bei jedem Auftreten unabhängig voneinander H, Halogen, geradkettiges, verzweigtes oder cyclisches Alkyl mit 1 bis 20 C-Atomen bedeutet, das unsubstituiert oder ein- oder mehrfach durch F, Cl, Br, I oder CN substituiert ist, worin gegebenenfalls eine oder mehrere nicht benachbarte $CH_2$-Gruppen jeweils unabhängig voneinander durch -O-, -S-, -NH-, $-NR^0-$, $-SiR^0R^{00}-$, -CO-, -COO-, -OCO-, -OCO-O-, $-SO_2-$, -S-CO-, -CO-S-, -CH=CH- oder -C≡C- so ersetzt sind, dass O- und/oder S-Atome nicht direkt miteinander verknüpft sind, oder bedeutet gegebenenfalls substituiertes Aryl oder Heteroaryl oder P-Sp-X,

$R^2$ eine der Bedeutungen von $R^1$ besitzt oder $-C{\equiv}C-R^3$ bedeutet,

$R^3$ eine der Bedeutungen von $R^1$ besitzt,

$R^0$ und $R^{00}$ unabhängig voneinander H oder Alkyl mit 1 bis 12 C-Atomen bedeuten,

P eine polymerisierbare oder reaktive Gruppe bedeutet,

Sp eine Spacergruppe oder eine Einfachbindung bedeutet,

B und D unabhängig voneinander $-CX^1=CX^2-$, -C≡C- oder gegebenenfalls substituiertes Arylen oder Heteroarylen bedeuten,

$X^1$ und $X^2$ unabhängig voneinander H, F, Cl oder CN bedeuten,

a, b, c, d unabhängig voneinander 0 oder 1 bedeuten, wobei a + b + c + d > 0, und worin in mindestens einer wiederkehrenden Einheit $[(A)_a\text{-}(B)_b\text{-}(C)_c\text{-}(D)_d]$ mindestens eines von a und c 1 bedeutet, und

n eine ganze Zahl ≥ 1 bedeutet,

und worin die wiederkehrenden Einheiten $[(A)_a\text{-}(B)_b\text{-}(C)_c\text{-}(D)_d]$ gleich oder verschieden sind.

**2.** Mono-, Oligo- und Polymere nach Anspruch 1, ausgewählt aus der Formel I1

$$R^4\text{-}[(A)_a\text{-}(B)_b\text{-}(C)_c\text{-}(D)_d]_n\text{-}R^5 \qquad \text{I1}$$

worin A, B, C, D, a, b, c, d und n wie in Formel I definiert sind,

$R^4$ und $R^5$ unabhängig voneinander eine der Bedeutungen von $R^1$ besitzen oder B(OR')(OR") oder -$SnR^0R^{00}R^{000}$ bedeuten,

$R^{0\text{-}000}$ unabhängig voneinander H oder Alkyl mit 1 bis 12 C-Atomen bedeuten, und

R' und R" unabhängig voneinander H oder Alkyl mit 1 bis 12 C-Atomen bedeuten oder OR' und OR" zusammen mit dem Boratom eine cyclische Gruppe mit 2 bis 10 C-Atomen bilden.

**3.** Mono-, Oligo- und Polymere nach Anspruch 1 oder 2, worin n eine ganze Zahl von 1 bis 5000 bedeutet.

**4.** Mono-, Oligo- und Polymere nach mindestens einem der Ansprüche 1 bis 3, worin $R^1$, $R^2$ und/oder $R^3$ ausgewählt sind aus $C_1$-$C_{20}$-Alkyl, das gegebenenfalls mit einem oder mehreren Fluoratomen substituiert ist, $C_1$-$C_{20}$-Alkenyl, $C_1$-$C_{20}$-Alkinyl, $C_1$-$C_{20}$-Alkoxy, $C_1$-$C_{20}$-Thioether, $C_1$-$C_{20}$-Silyl, $C_1$-$C_{20}$-Ester, $C_1$-$C_{20}$-Amino, $C_1$-$C_{20}$-Fluoralkyl oder gegebenenfalls substituiertes Aryl oder Heteroaryl bedeuten.

**5.** Mono-, Oligo- und Polymere nach Anspruch 4, worin $R^2$ $-C{\equiv}C\text{-}R^3$ bedeutet und $R^1$ und $R^3$ gleiche Gruppen wie in Formel I definiert bedeuten.

**6.** Mono-, Oligo- und Polymere nach mindestens einem der Ansprüche 2 bis 5, worin n eine ganze Zahl von 1 bis 15 bedeutet und eines oder beide von $R^4$ und $R^5$ P-Sp- bedeuten.

**7.** Oligo- und Polymere nach mindestens einem der Ansprüche 1 bis 6, worin n eine ganze Zahl von 2 bis 5000 bedeutet.

**8.** Mono-, Oligo- und Polymere nach mindestens einem der Ansprüche 1 bis 7, worin P ausgewählt ist aus $CH_2{=}CW^1\text{-}COO\text{-}$,

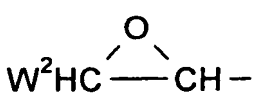 , 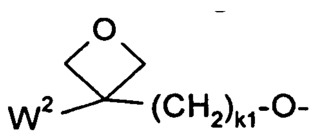 ,

$CH_2{=}CW^2\text{-}(O)_{k1}\text{-}$, $CH_3\text{-}CH{=}CH\text{-}O\text{-}$, $(CH_2{=}CH)_2CH\text{-}OCO\text{-}$, $(CH_2{=}CH\text{-}CH_2)_2CH\text{-}OCO\text{-}$, $(CH_2{=}CH)_2CH\text{-}O\text{-}$, $(CH_2{=}CH\text{-}CH_2)_2N\text{-}$, $HO\text{-}CW^2W^3\text{-}$, $HS\text{-}CW^2W^3\text{-}$, $HW^2N\text{-}$, $HO\text{-}CW^2W^3\text{-}NH\text{-}$, $CH_2{=}CW^1\text{-}CO\text{-}NH\text{-}$, $CH_2{=}CH\text{-}(COO)_{k1}\text{-}Phe\text{-}(O)_{k2}\text{-}$, Phe-CH=CH-, HOOC-, OCN- und $W^4W^5W^6Si\text{-}$, wobei $W^1$ H, Cl, CN, Phenyl oder Alkyl mit 1 bis 5 C-Atomen, insbesondere H, Cl oder $CH_3$ bedeutet, $W^2$ und $W^3$ unabhängig voneinander H oder Alkyl mit 1 bis 5 C-Atomen, insbesondere Methyl, Ethyl oder n-Propyl bedeuten, $W^4$, $W^5$ und $W^6$ unabhängig voneinander Cl, Oxaalkyl oder Oxacarbonylalkyl mit 1 bis 5 C-Atomen bedeuten, Phe 1,4-Phenylen bedeutet und $k_1$ und $k_2$ unabhängig voneinander 0 oder 1 bedeuten.

**9.** Mono-, Oligo- und Polymere nach mindestens einem der Ansprüche 1 bis 8, ausgewählt aus den folgenden Formeln

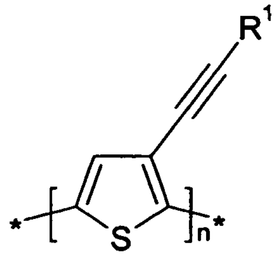

Ia

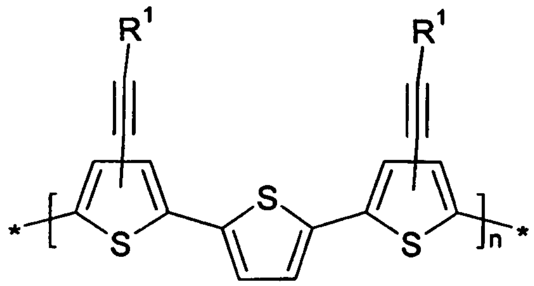

Ib

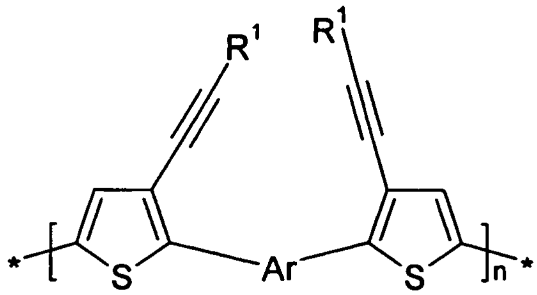

Ic

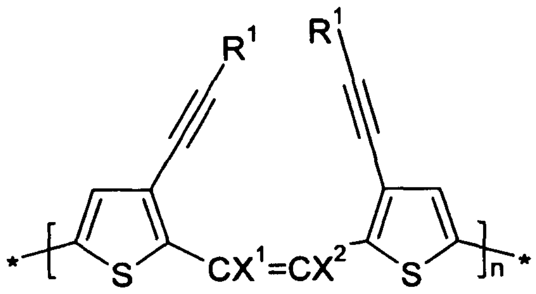

Id

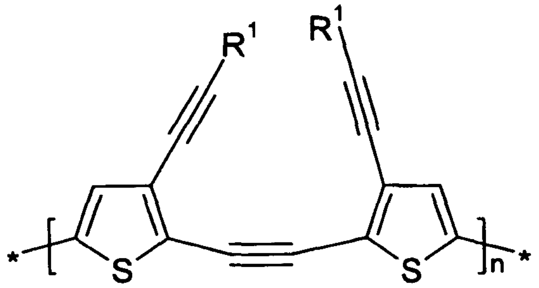

Ie

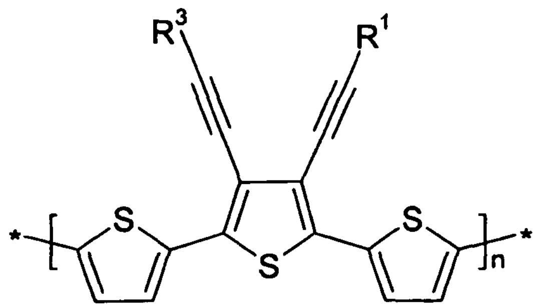

If

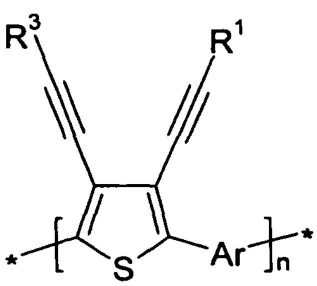

Ig

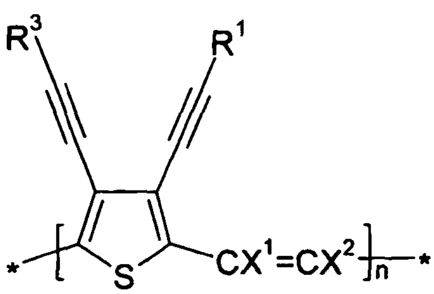

Ih

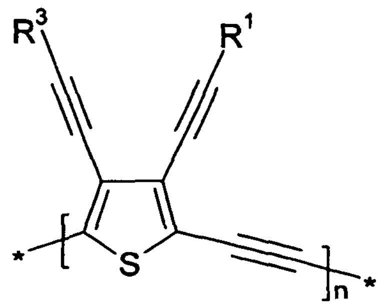

Ii

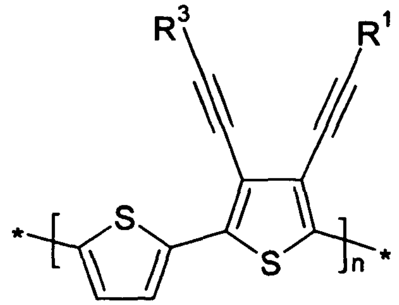

Ik

worin $R^1$, $R^3$, $X^1$ und $X^2$ die in Formel I angegebenen Bedeutungen besitzen, Ar Arylen oder Heteroarylen bedeutet, das jeweils gegebenenfalls durch eine oder mehrere Gruppen $R^1$ wie in Formel I definiert substituiert ist, und n bedeutet eine ganze Zahl von 1 bis 5000.

**10.** Polymer nach mindestens einem der Ansprüche 1 bis 9, **dadurch gekennzeichnet, dass** seine Regioregularität 90 bis 100% beträgt.

**11.** Polymerisierbares Flüssigkristallmaterial enthaltend ein oder mehrere Mono-, Oligo- oder Polymere nach mindestens einem der Ansprüche 1 bis 10 enthaltend mindestens eine polymerisierbare Gruppe und gegebenenfalls enthaltend eine oder mehrere weitere polymerisierbare Verbindungen, worin mindestens eines/eine der polymerisierbaren Mono-, Oligo- und Polymere der Ansprüche 1 bis 8 und/oder der weiteren polymerisierbaren Verbindungen mesogen oder flüssigkristallin ist.

**12.** Anisotrope Polymerfolie mit ladungstransportierenden Eigenschaften, erhältlich aus einem polymerisierbaren Flüssigkristallmaterial nach Anspruch 11, das in seiner Flüssigkristallphase in makroskopisch uniforme Ausrichtung orientiert und zur Fixierung des ausgerichteten Zustandes polymerisiert oder vernetzt ist.

**13.** Seitenketten-Flüssigkristallpolymer erhalten durch Polymerisation eines oder mehrerer Mono- oder Oligomere oder eines polymerisierbaren Materials nach den Ansprüchen 1 bis 11 oder durch Aufpfropfen eines oder mehrerer Mono- oder Oligomere oder eines polymerisierbaren Materials nach den Ansprüchen 1 bis 11 in einer polymeranalogen Reaktion auf ein Polymerrückgrat, gegebenenfalls mit einem oder mehreren zusätzlichen mesogenen oder nicht mesogenen Comonomeren.

**14.** Verwendung der Mono-, Oligo- und Polymere, des polymerisierbaren Materials und des Polymeren der Ansprüche 1 bis 13 als Halbleiter oder Ladungstransportmaterialien, insbesondere in optischen, elektrooptischen oder elektronischen Vorrichtungen, wie beispielsweise Komponenten integrierter Schaltungen, Feldeffekttransistoren (FET), beispielsweise als Dünnfilmtransistoren in Flachbildschirm-Anwendungen oder für RFID-Tags (Radio Frequency Identification), oder in Halbleiterkomponenten für Anwendungen mit organischen Leuchtdioden (OLED) wie Elektrolumineszenzanzeigen oder Hintergrundlichter von z.B. Flüssigkristallanzeigen, für photovoltaische oder Sensorvorrichtungen, als Elektrodenmaterialien in Batterien, als Photoleiter und für elektrophotographische Anwendungen wie elektrophotographische Aufzeichnung.

15. Feldeffekttransistor, beispielsweise als Komponente integrierter Schaltungen, als Dünnfilmtransistor in Flachbildschirm-Anwendungen oder in einem RFID-Tag (Radio Frequency Identification), enthaltend ein oder mehrere erfindungsgemäße Mono-, Oligo- oder Polymere enthaltend ein oder mehrere Mono-, Oligo- oder Polymere, polymerisierbares Material oder Polymer der Ansprüche 1 bis 13.

16. Sicherheitsmarkierung oder -vorrichtung enthaltend ein oder mehrere Mono-, Oligo- oder Polymere, ein polymerisierbares Material oder ein Polymer der Ansprüche 1 bis 13 oder einen FET oder ein RFID-Tag nach Anspruch 15.

17. Mono-, Oligo- und Polymere, ein Material oder Polymer nach mindestens einem der Ansprüche 1 bis 13, die oxidativ oder reduktiv dotiert sind, so dass sie leitende Ionenspezies bilden.

18. Ladungsinjektionsschicht, Planarisierungsschicht, Antistatikfolie oder leitendes Substrat oder Muster für Elektronikanwendungen oder Flachbildschirme, enthaltend Mono-, Oligo- oder Polymere, ein Material oder eine Polymerfolie nach Anspruch 17.

## Revendications

1. Monomères, oligomères et polymères de la formule I

$$-[(A)_a-(B)_b-(C)_c-(D)_d]_n- \qquad I$$

dans laquelle

A et C représentent indépendamment l'un de l'autre un groupe de la formule II

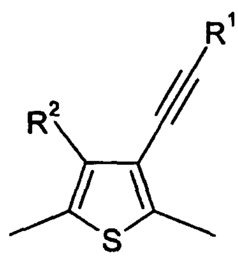

II

$R^1$ est, pour chaque occurrence indépendamment d'une autre, H, halogène, alkyle en chaîne droite, ramifié ou cyclique avec de 1 à 20 atomes de C, qui est non substitué, monosubstitué ou polysubstitué par F, Cl, Br, I ou CN, où un ou plusieurs groupes $CH_2$ non adjacents sont en option remplacés, dans chaque cas indépendamment les uns des autres, par -O-, -S-, -NH-, $-NR^0-$, $-SiR^0R^{00}-$, -CO-, -COO-, -OCO-, -OCO-O-, $-SO_2-$, -S-CO-, -CO-S-, -CH=CH- ou -C≡C- de telle sorte que des atomes de O et/ou de S ne soient pas liés directement les uns aux autres, ou représente en option aryle ou hétéroaryle ou P-Sp-X substitué,

$R^2$ présente l'un des significations de $R^1$ ou représente $-C{\equiv}C-R^3$,

$R^3$ présente l'une des significations de $R^1$,

$R^0$ et $R^{00}$ sont, indépendamment l'un de l'autre, H ou alkyle avec de 1 à 12 atomes de C,

P est un groupe polymérisable ou réactif,

Sp est un groupe d'espaceur ou une liaison simple,

B et D sont, indépendamment l'un de l'autre, $-CX^1=CX^2-$, -C≡C-, ou en option arylène ou hétéroarylène

substitué,

$X^1$ et $X^2$ sont, indépendamment l'un de l'autre, H, F, Cl ou CN,

a, b, c, d sont, indépendamment les uns des autres, 0 ou 1, avec a + b + c + d > 0, et où, dans au moins une unité récurrente $[(A)_a\text{-}(B)_b\text{-}(C)_c\text{-}(D)_d]$, au moins l'un de a et c vaut 1, et

n est un entier ≥ 1,

et dans lesquels les unités récurrentes $[(A)_a\text{-}(B)_b\text{-}(C)_c\text{-}(D)_d]$ sont identiques ou différentes.

**2.** Monomères, oligomères et polymères selon la revendication 1, choisis à partir de la formule I1

$$R^4\text{-}[(A)_a\text{-}(B)_b\text{-}(C)_c\text{-}(D)_d]_n\text{-}R^5 \qquad \text{I1}$$

dans laquelle A, B, C, D, a, b, c, d et n sont comme défini selon la formule I,
$R^4$ et $R^5$ présentent, indépendamment l'un de l'autre, l'une des significations de $R^1$ ou représentent B(OR')(OR") ou $SnR^0R^{00}R^{000}$,
$R^{0\text{-}000}$ sont, indépendamment les uns des autres, H ou alkyle avec de 1 à 12 atomes de C, et
R' et R" sont, indépendamment l'un de l'autre, H ou alkyle avec de 1 à 12 atomes de C, ou OR' et OR" en association avec l'atome de bore forment un groupe cyclique comportant de 2 à 10 atomes de C.

**3.** Monomères, oligomères et polymères selon la revendication 1 ou 2, dans lesquels n est un entier compris entre 1 et 5000.

**4.** Monomères, oligomères et polymères selon la revendication 1 à 3, dans lesquels $R^1$, $R^2$ et/ou $R^3$ sont choisis à partir de $C_1$-$C_{20}$-alkyle qui est en option substitué avec un ou plusieurs atomes de fluor, $C_1$-$C_{20}$-alkényle, $C_1$-$C_{20}$-alkynyle, $C_1$-$C_{20}$-alkoxy, $C_1$-$C_{20}$-thioéther, $C_1$-$C_{20}$-silyle, $C_1$-$C_{20}$-ester, $C_1$-$C_{20}$-amino, $C_1$-$C_{20}$-fluoroalkyle, ou en option aryle ou hétéroaryle substitué.

**5.** Monomères, oligomères et polymères selon la revendication 4, dans lesquels $R^2$ est $-C{\equiv}C\text{-}R^3$ et $R^1$ et $R^3$ sont des groupes identiques comme défini selon la formule I.

**6.** Monomères, oligomères et polymères selon au moins l'une des revendications 2 à 5, dans lesquels n est un entier compris entre 1 et 15 et l'un de $R^4$ et $R^5$ ou les deux représentent P-Sp-.

**7.** Oligomères et polymères selon au moins l'une des revendications 1 à 6, dans lesquels n est un entier compris entre 2 et 5000.

**8.** Monomères, oligomères et polymères selon au moins l'une des revendications 1 à 7, dans lesquels P est choisi parmi $CH_2{=}CW^1\text{-}COO\text{-}$,

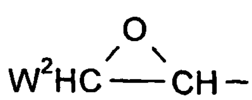 , 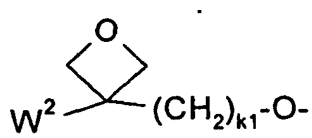 ,

$CH_2{=}CW^2\text{-}(O)_{k1}\text{-}$, $CH_3\text{-}CH{=}CH\text{-}O\text{-}$, $(CH_2{=}CH)_2CH\text{-}OCO\text{-}$, $(CH_2{=}CH\text{-}CH_2)_2CH\text{-}OCO$, $(CH_2{=}CH)_2CH\text{-}O\text{-}$, $(CH_2{=}CH\text{-}CH_2)_2N\text{-}$, $HO\text{-}CW^2W^3\text{-}$, $HS\text{-}CW^2W^3\text{-}$, $HW^2N\text{-}$, $HO\text{-}CW^2W^3\text{-}NH\text{-}$, $CH_2{=}CW^1\text{-}CO\text{-}NH\text{-}$, $CH_2{=}CH\text{-}(COO)_{k1}\text{-}Phe\text{-}(O)_{k2}\text{-}$, Phe-CH=CH-, HOOC-, OCN- et $W^4W^5W^6Si\text{-}$, avec $W^1$ qui est H, Cl, CN, phényle ou alkyle avec de 1 à 5 atomes de C, en particulier H, Cl ou $CH_3$, $W^2$ et $W^3$ étant indépendamment l'un de l'autre H ou alkyle avec de 1 à 5 atomes de C, en particulier méthyle, éthyle ou n-propyle, $W^4$, $W^5$ et $W^6$ étant indépendamment les uns des autres Cl, oxaalkyle ou oxacarbonylalkyle avec de 1 à 5 atomes de C, Phe étant 1,4-phénylène et $k_1$ et $k_2$ étant indépendamment l'un de l'autre 0 ou 1.

9. Monomères, oligomères et polymères selon au moins l'une des revendications 1 à 8, choisis parmi les formules qui suivent

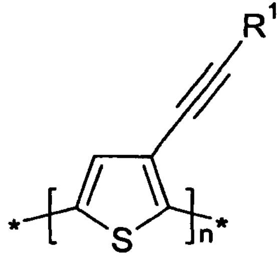

Ia

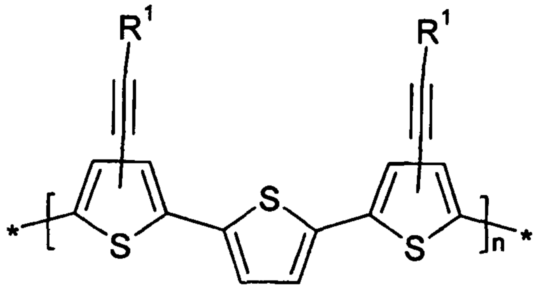

Ib

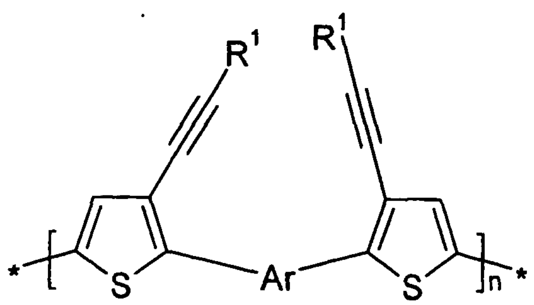

Ic

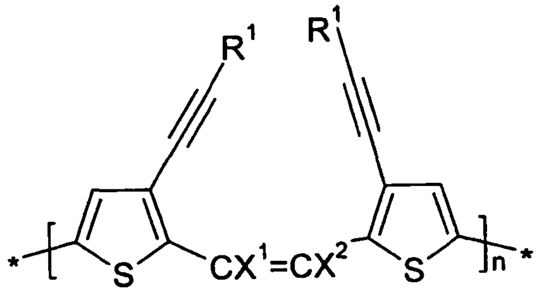

Id

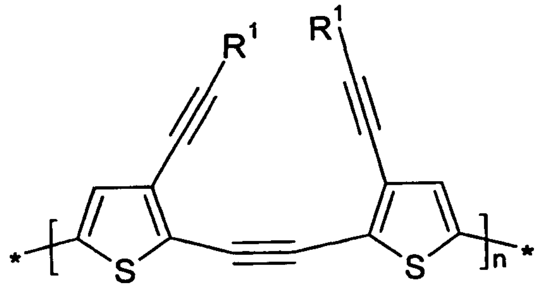

Ie

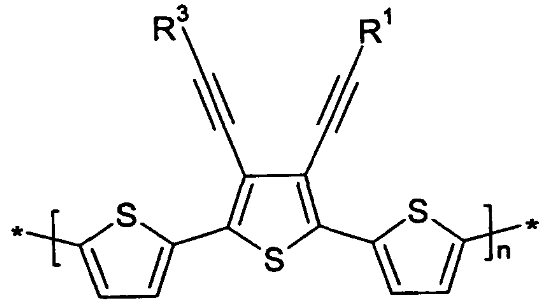

If

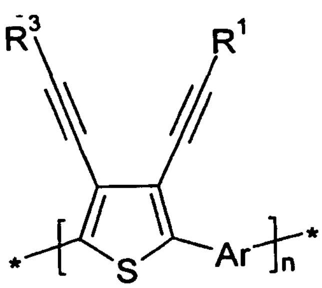

Ig

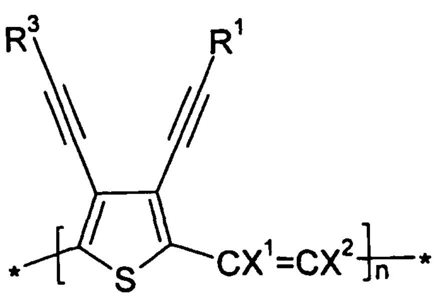

Ih

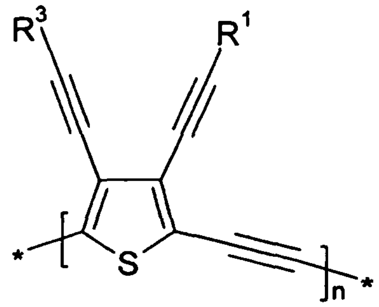

Ii

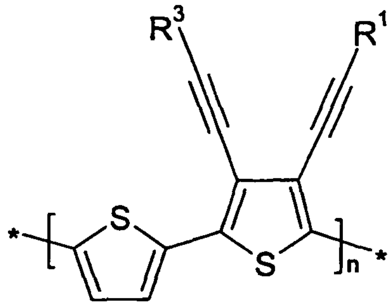

Ik

dans lesquelles $R^1$, $R^3$, $X^1$ et $X^2$ présentent les significations données selon la formule I, Ar est arylène ou hétéroarylène qui, dans chaque cas, est en option substitué par un ou plusieurs groupes $R^1$ comme défini selon la formule I, et n est un entier compris entre 1 et 5000.

**10.** Polymère selon au moins l'une des revendications 1 à 9, **caractérisé en ce qu'**il présente une régiorégularité de 90% à 100%.

**11.** Matériau de cristal liquide polymérisable comprenant un ou plusieurs monomères, oligomères ou polymères selon au moins l'une des revendications 1 à 10, comprenant au moins un groupe polymérisable et comprenant en option un ou plusieurs autres composés polymérisables, dans lequel au moins l'un des monomères, oligomères et polymères polymérisables des revendications 1 à 8 et/ou des autres composés polymérisables est mésogène ou cristallin liquide.

**12.** Film en polymère anisotrope avec des propriétés de transport de charges pouvant être obtenu à partir d'un matériau de cristal liquide polymérisable selon la revendication 11 qui est aligné dans sa phase de cristal liquide selon une orientation uniforme macroscopiquement et qui est polymérisé ou réticulé afin de fixer l'état orienté.

**13.** Polymère de cristal liquide à chaîne latérale obtenu par polymérisation d'un ou de plusieurs monomères ou oligomères ou d'un matériau polymérisable selon les revendications 1 à 11 ou par greffage d'un ou de plusieurs monomères ou oligomères ou d'un matériau polymérisable selon les revendications 1 à 11 sur un squelette polymérique au niveau d'une réaction analogue à une polymérisation, en option avec un ou plusieurs comonomères mésogènes ou non mésogènes additionnels.

**14.** Utilisation des monomères, des oligomères et des polymères, du matériau polymérisable et du polymère des revendications 1 à 13 en tant que semiconducteurs ou en tant que matériaux de transport de charges, en particulier dans des dispositifs optiques, électro-optiques ou électroniques tels que par exemple des composants de circuit intégré, des transistors à effet de champ (FET), par exemple en tant que transistors à film mince dans des applications d'affichage à écran plat ou pour des étiquettes d'identification radio fréquence (RFID), ou dans des composants semiconducteurs pour des applications par diode émettrice de lumière organique (DELO) telles que des affichages électroluminescents ou que des éclairages arrière de par exemple des affichages à cristaux liquides, pour des dispositifs photovoltaïques ou de capteur, en tant que matériaux d'électrode dans des accumulateurs, en tant que photoconducteurs et pour des applications électrophotographiques telles qu'un enregistrement électrophotographique.

**15.** Transistor à effet de champ, par exemple en tant que composant de circuit intégré, en tant que transistor à film mince dans des applications d'affichage à écran plat ou dans une étiquette d'identification radio fréquence (RFID), comprenant un ou plusieurs monomères, oligomères ou polymères selon l'invention comprenant un ou plusieurs monomères, oligomères ou polymères, un matériau polymérisable ou un polymère selon les revendications 1 à 13.

**16.** Marquage de sécurité ou dispositif comprenant un ou plusieurs monomères, oligomères ou polymères, un matériau polymérisable ou un polymère selon les revendications 1 à 13, ou un FET ou une étiquette RFID selon la revendication 15.

**17.** Monomères, oligomères et polymères, matériau ou polymère selon au moins l'une des revendications 1 à 13, qui sont dopés par oxydation ou par réduction afin de former des espèces ioniques conductrices.

**18.** Couche d'injection de charges, couche de planarisation, film antistatique ou substrat conducteur ou motif pour des applications électroniques ou des affichages à écran plat comprenant des monomères, des oligomères ou des polymères, un matériau ou un film en polymère selon la revendication 17.